(19) Europäisches Patentamt / European Patent Office / Office européen des brevets

(11) **EP 2 599 232 B1**

(12) **FASCICULE DE BREVET EUROPEEN**

(45) Date de publication et mention de la délivrance du brevet:
**21.05.2014 Bulletin 2014/21**

(21) Numéro de dépôt: **11743871.3**

(22) Date de dépôt: **07.07.2011**

(51) Int Cl.:
*H04B 1/7163* (2011.01)    *H04B 1/717* (2011.01)

(86) Numéro de dépôt international:
**PCT/IB2011/053015**

(87) Numéro de publication internationale:
**WO 2012/014107 (02.02.2012 Gazette 2012/05)**

(54) **PROCEDE ET DISPOSITIF DE GENERATION D'IMPULSIONS ULTRA LARGE BANDE (UWB)**

VERFAHREN UND VORRICHTUNG ZUR ERZEUGUNG VON ULTRABREITBAND (UWB)-IMPULSEN

METHOD AND DEVICE FOR GENERATING ULTRA WIDE BAND PULSES (UWB)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.09.2010 US 875033**
            **27.07.2010 FR 1003137**

(43) Date de publication de la demande:
**05.06.2013 Bulletin 2013/23**

(73) Titulaire: **Université d'Aix-Marseille**
**13284 Marseille Cedex 07 (FR)**

(72) Inventeurs:
• **BOURDEL, Sylvain**
**F-13820 Ensues La Redonne (FR)**
• **VAUCHE, Rémi**
**F-83 000 Toulon (FR)**

(74) Mandataire: **de Roquemaurel, Bruno et al**
**OMNIPAT**
**24 Place des Martyrs de la Résistance**
**13100 Aix en Provence (FR)**

(56) Documents cités:
• **VAUCHE R ET AL: "Fully tunable UWB pulse generator with zero DC power consumption", ULTRA-WIDEBAND, 2009. ICUWB 2009. IEEE INTERNATIONAL CONFERENCE ON, IEEE, PISCATAWAY, NJ, USA, 9 septembre 2009 (2009-09-09), pages 418-422, XP031547693, ISBN: 978-1-4244-2930-1**
• **KIM H ET AL: "All-digital low-power CMOS pulse generator for UWB system", ELECTRONICS LETTERS, IEE STEVENAGE, GB, vol. 40, no. 24, 25 novembre 2004 (2004-11-25), pages 1534-1535, XP006022975, ISSN: 0013-5194, DOI: DOI:10.1049/EL:20046923**
• **BOURDEL S ET AL: "Low-cost CMOS pulse generator for UWB systems", ELECTRONICS LETTERS, IEE STEVENAGE, GB, vol. 43, no. 25, 6 décembre 2007 (2007-12-06), pages 1425-1427, XP006030069, ISSN: 0013-5194, DOI: DOI:10.1049/EL:20072616**
• **YUN HWA CHOI: "Gated uwb pulse signal generation", ULTRA WIDEBAND SYSTEMS, 2004. JOINT WITH CONFERENCE ON ULTRAWIDEBAND S YSTEMS AND TECHNOLOGIES. JOINT UWBST & IWUWBS. 2004 INTERNATIONAL WORK SHOP ON KYOTO, JAPAN MAY 18-21, 2004, PISCATAWAY, NJ, USA, IEEE, 18 mai 2004 (2004-05-18), pages 122-124, XP010716232, ISBN: 978-0-7803-8373-9**

**Description**

La présente invention concerne un générateur d'impulsion ultra large bande. La présente invention s'applique notamment, mais non exclusivement aux communications sans fil.

En raison d'une demande croissante de communications sans fil, de nouvelles bandes de fréquences sont attribuées aux transmissions ultra large bande UWB (Ultra Wide Band). La largeur de ces bandes de fréquence est telle qu'elle autorise la mise en oeuvre de techniques de transmission par impulsions qui permettent de simplifier l'architecture des émetteurs et des récepteurs. En effet, contrairement aux communications sans fil classiques, les transmissions par impulsion ne nécessitent pas la mise en oeuvre de fonctions de synthèse de fréquence et de mélange de signaux qui sont coûteuses en termes de consommation électrique et de surface de circuit intégré. Toutefois, des contraintes de Densité Spectrale de Puissance (DSP) ont été définies pour éviter les interférences avec d'autres systèmes de communication. En particulier, les commissions nationales de régulation des transmissions (Federal Communications Commission - FCC aux USA et ETSI - European Telecommunications Standards Institute en Europe) imposent des masques de densité spectrale de puissance pour les transmissions par impulsions radio UWB - IR, qui nécessitent une mise en forme les impulsions émises particulièrement délicate à mettre en oeuvre.

A cet effet, il est connu de réaliser un générateur d'impulsion ultra large bande à l'aide de circuits passifs et de transformateurs (voir documents [1], [2] et [3]), ou de filtres analogiques de mise en forme (voir document [4]), ou encore de diodes de type "Step Recovery" (SRD) (voir document [5]). Toutefois, ces circuits et composants présentent l'inconvénient d'empêcher un taux d'intégration élevé, notamment en raison de la présence d'inductances, ou de ne pas être réalisables en technologie CMOS standard de faible coût, notamment en raison de la présence de diodes SRD. Ces techniques présentent également l'inconvénient de ne générer qu'une forme d'impulsion figée qui n'est pas adaptable.

Il existe également des techniques pour générer des impulsions variables. A cet effet, il est connu d'utiliser un oscillateur local et un mélangeur pour transposer différentes impulsions produites en bande de base, dans différentes bandes de fréquence (voir documents [6], [7]). Toutefois cette technique provoque des fuites et l'amplitude des impulsions générées est limitée. En outre l'énergie électrique consommée par impulsion par rapport à l'amplitude de l'impulsion est relativement élevée.

Il a également été proposé de réaliser des générateurs d'impulsion entièrement numériques (voir documents [8], [9], [10]). Toutefois, cette solution entraîne une limitation en fréquence et en amplitude qui dépend de la rapidité des circuits. Compte tenu des performances des meilleurs circuits intégrés actuels, cette solution n'est guère envisageable pour générer des impulsions d'amplitude suffisante (> 1 V) au delà 5 GHz.

Dans ce contexte, il est souhaitable de réaliser un générateur d'impulsion qui soit aussi compact que possible et de faible consommation électrique, tout en étant capable de générer des impulsions d'amplitude élevée pour pouvoir être utilisés dans des systèmes de faible coût basés sur la détection d'énergie. Il est également souhaitable que le générateur d'impulsion puisse fonctionner dans différentes bandes de fréquences et s'adapter à différentes applications. A cet effet, le générateur d'impulsion devrait être capable de synthétiser des impulsions dans de très larges gammes de formes et d'amplitude, dans des bandes de fréquences situées entre 500 MHz et quelques GHz et avec une répétitivité de plusieurs centaines de MHz. Pour des raisons de coût, il est également souhaitable que le générateur d'impulsion puisse être réalisé en technologie CMOS standard.

Il est également souhaitable de pouvoir agir sur la forme des impulsions générées pour compenser des dérives de fonctionnement de circuits d'émission et de réception de signaux, liées à des variations de conditions de fabrication de ces circuits, ainsi qu'à des variations de tension d'alimentation et de température de ces circuits, couramment appelées "variations PVT" (Process, Voltage, Temperature). Les systèmes existants ne permettent pas de reprogrammer la forme d'une impulsion, notamment en raison de l'utilisation de circuits purement passifs.

Des modes de réalisation concernent un procédé de génération de formes d'onde UWB comprenant chacune une séquence d'impulsions élémentaires, le procédé comprenant des étapes consistant à : générer au moins deux signaux d'impulsion comportant chacun un train d'impulsions élémentaires sensiblement de même amplitude et de durée correspondant à une durée de consigne, les impulsions élémentaires apparaissant alternativement dans l'un et l'autre des deux trains d'impulsions, pour chaque signal d'impulsion, générer un signal d'amplitude fournissant pour chaque impulsion élémentaire et lors de son apparition dans le signal d'impulsion, une consigne d'amplitude de l'impulsion élémentaire, et combiner les signaux d'impulsion et les signaux d'amplitude pour obtenir une forme d'onde comprenant successivement chacune des impulsions élémentaires amplifiées, et alternativement positives et négatives, les impulsions élémentaires étant amplifiées conformément à la consigne d'amplitude de l'impulsion élémentaire, fournie par l'un des signaux d'amplitude.

Selon un mode de réalisation, les trains d'impulsions élémentaires sont générés par un oscillateur fournissant un signal dont la période peut être ajustée à une valeur correspondant à la durée de consigne.

Selon un mode de réalisation, les impulsions élémentaires sont amplifiées et combinées dans un circuit à pont en H comprenant au moins une première branche recevant un premier des signaux d'impulsion et le signal d'amplitude correspondant, et au moins une seconde branche recevant un second des signaux d'impulsion et le signal d'amplitude correspondant.

Selon un mode de réalisation, le signal d'impulsion est introduit dans une branche du circuit à pont en H par la grille d'au moins deux transistors montés en série dans la branche.

Selon un mode de réalisation, l'un des signaux d'amplitude est introduit dans une branche du circuit à pont en H par la grille d'au moins deux transistors montés en série dans la branche.

Selon un mode de réalisation, le procédé comprend des étapes de génération d'une forme d'onde de polarité positive et de génération d'une forme d'onde de polarité négative, la forme d'onde de polarité négative comprenant un même nombre d'impulsions élémentaires que la forme d'onde de polarité positive, chaque impulsion élémentaire dans l'une des formes d'onde ayant la même amplitude et une polarité opposée à une impulsion élémentaire de même rang dans l'autre forme d'onde.

Selon un mode de réalisation, les impulsions élémentaires sont amplifiées et combinées dans un circuit à pont en H, une forme d'onde de polarité positive étant générée en introduisant un premier des deux signaux d'impulsion dans une branche impaire du circuit à pont en H, et un second des signaux d'impulsion dans une branche paire du circuit à pont en H, une forme d'onde de polarité négative étant générée en introduisant le premier signal d'impulsion dans la branche paire du circuit à pont en H, et le second signal d'impulsion dans la branche impaire du circuit à pont en H.

Des modes de réalisation concernent également un procédé de transmission de données binaires, comprenant des étapes de génération d'une forme d'onde de polarité positive ou négative, selon qu'une donnée binaire à 0 ou à 1 est transmise, et d'émission des formes d'onde générées, la forme d'onde de polarité négative comprenant un même nombre d'impulsions élémentaires que la forme d'onde de polarité positive, chaque impulsion élémentaire dans l'une des formes d'onde ayant la même amplitude et une polarité opposée à une impulsion élémentaire de même rang dans l'autre forme d'onde, la génération des formes d'onde étant réalisée conformément au procédé de génération défini précédemment.

Selon un mode de réalisation, le procédé de transmission comprend une phase de calibration comportant plusieurs étapes de transmission d'un message de calibration, chaque étape de transmission consistant à : générer une forme d'onde distincte en ce qui concerne les amplitudes et/ou les durées de ses impulsions élémentaires, identifiée par un identifiant de forme d'onde, émettre un message de calibration contenant l'identifiant de forme d'onde, à l'aide de la forme d'onde, et recevoir le message de calibration et déterminer une mesure de qualité de transmission à partir du message de calibration reçu, le procédé comprenant une étape finale de sélection d'une forme d'onde parmi les formes d'ondes utilisées pour transmettre un message de calibration, en fonction des mesures de qualité de transmission obtenues.

Des modes de réalisation concernent également un générateur de forme d'onde UWB comprenant un générateur d'impulsions configuré pour mettre en œuvre le procédé de génération tel que défini précédemment.

Selon un mode de réalisation, le générateur comprend un oscillateur produisant un signal de sortie ayant une fréquence commandée en fonction d'une durée de consigne, et définissant la durée des impulsions élémentaires.

Selon un mode de réalisation, l'additionneur comprend un pont en H comportant au moins une première branche recevant un premier des signaux d'impulsions et le signal d'amplitude du premier signal impulsion, et au moins une seconde branche recevant un second des signaux d'impulsions et le signal d'amplitude du second signal d'impulsion.

Selon un mode de réalisation, chaque branche de l'additionneur comprend au moins deux transistors montés en série dans la branche et recevant sur leur grille l'un des signaux d'impulsion élémentaire à amplifier et combiner.

Selon un mode de réalisation, chaque de l'additionneur comprend au moins deux transistors montés en série dans la branche et recevant sur leur grille l'un des signaux d'amplitude.

Des modes de réalisation concernent également un émetteur comprenant un générateur de forme d'onde tel que défini précédemment.

Des exemples de réalisation de l'invention seront décrits dans ce qui suit, à titre non limitatif en relation avec les figures jointes parmi lesquelles :

les figures 1a et 1b représentent des décompositions de formes d'onde en impulsions élémentaires,
la figure 2 représente un schéma de principe d'un générateur de forme d'onde selon un mode de réalisation,
la figure 2a représente un chronogramme d'une forme d'onde générée par le générateur de forme d'onde,
la figure 3 est un schéma électrique d'un circuit de génération d'impulsions élémentaires du générateur de forme d'onde, selon un mode de réalisation,
la figure 4 est un schéma électrique d'un circuit d'addition de signaux du générateur de forme d'onde, selon un mode de réalisation,
la figure 5 représente schématiquement la structure d'un mot de commande du générateur de forme d'onde,
les figures 6 à 8 sont des schémas électriques de circuits du générateur d'impulsions élémentaires, selon un mode de réalisation,
les figures 9a à 9d représentent des chronogrammes illustrant différents cas de fonctionnement d'un circuit du générateur d'impulsions élémentaires,

les figures 10a, 10b, 11a, 11b sont des courbes illustrant le fonctionnement du générateur de forme d'onde,

les figures 12 à 14 sont des schémas électriques de circuits d'addition de signaux du générateur de forme d'onde, selon d'autres modes de réalisation,

les figures 15a à 15d représentent des chronogrammes illustrant le fonctionnement du générateur de forme d'onde, la figure 16 est un schéma électrique d'un circuit de génération d'impulsions élémentaires du générateur de forme d'onde, selon un autre mode de réalisation,

la figure 17 représente un schéma de principe d'un générateur de forme d'onde selon un autre mode de réalisation, la figure 17a représente un chronogramme d'une forme d'onde générée par le générateur de forme d'onde de la figure 17,

les figures 18 à 20 sont des schémas électriques de circuits du générateur de forme d'onde de la figure 17, selon un mode de réalisation,

la figure 21 représente schématiquement la structure d'un mot de commande du générateur de forme d'onde de la figure 17,

les figures 22a à 22e sont des courbes illustrant le fonctionnement du générateur de forme d'onde de la figure 17, les figures 23 et 24 représentent des schémas électriques de circuits du générateur de forme d'onde de la figure 17, selon un autre mode de réalisation,

la figure 25 représente un circuit de calibration du générateur de forme d'onde, selon un mode de réalisation,

la figure 26 représente un système de transmission de données mettant en oeuvre le générateur de forme d'onde.

Une forme d'onde s(t) peut être décomposée en une série de N impulsions élémentaires ei(t) de largeur (ou durée) di et d'amplitude gi (i variant de 1 à N), conformément à l'équation (1) suivante :

$$s(t) = \sum_{i=1}^{N} g_i \cdot e_i\left(t - \sum_{j=0}^{i-1} d_j\right) \text{ avec } d_0 = 0 \qquad (1)$$

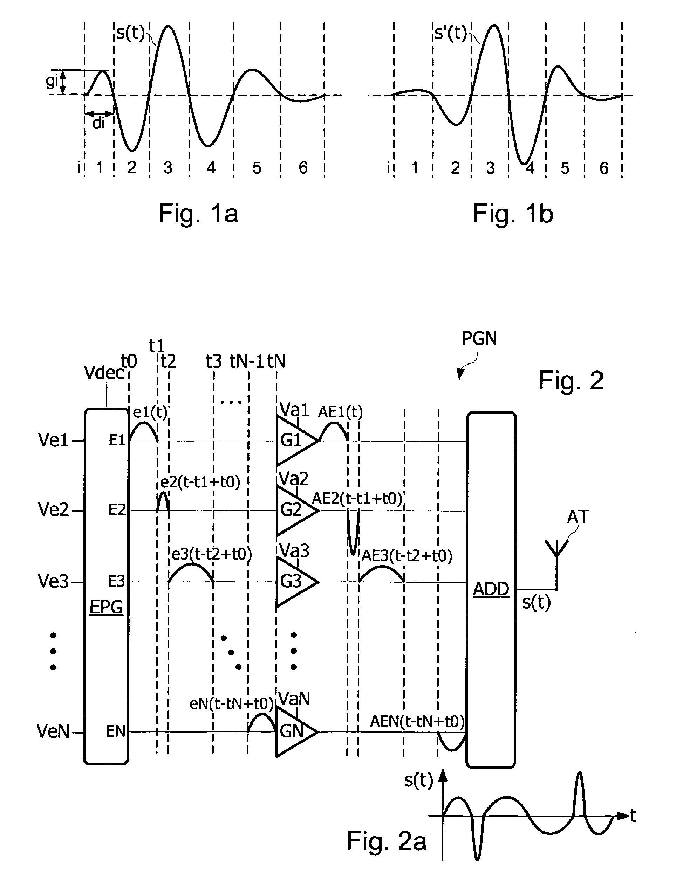

La figure 1a représente une forme d'onde s(t) correspondant à la réponse impulsionnelle d'un filtre de Bessel de bande passante entre 6 et 10 GHz. Les valeurs d'amplitude gi et de durée di de chaque impulsion élémentaire i de la forme d'onde s(t) sont rassemblées dans le tableau 1 suivant :

Tableau 1

| i | 1 | 2 | 3 | 4 | 5 | 6 |
|---|---|---|---|---|---|---|
| gi | 0.35 | -0.8 | 1 | -0.75 | 0.37 | -0.12 |
| di | 42 | 48 | 64 | 70 | 80 | 91 |

La figure 1b représente une forme d'onde s'(t) correspondant à la cinquième dérivée d'une impulsion gaussienne. Les valeurs d'amplitude gi et de durée di de chaque impulsion élémentaire i de la forme d'onde s'(t) sont rassemblées dans le tableau 2 suivant :

Tableau 2

| i | 1 | 2 | 3 | 4 | 5 | 6 |
|---|---|---|---|---|---|---|
| gi | 0.06 | -0.43 | 1 | -1 | 0.43 | -0.06 |
| di | 85 | 76 | 68 | 68 | 76 | 85 |

La figure 2 représente un générateur de forme d'onde PGN selon un mode de réalisation. Conformément au principe de la décomposition d'une forme d'onde en impulsions élémentaires, le générateur de forme d'onde PGN comprend un générateur d'impulsions élémentaires EPG comprenant N entrées de signaux de consigne de durée Ve1, Ve2, ... VeN, une entrée de déclenchement Vdec, et N sorties d'impulsions élémentaires O1, 02, 03, EN fournissant chacune successivement une impulsion élémentaire e1, e2, ... eN. Chaque sortie d'impulsion élémentaire est connectée à un amplificateur G1, G2, ... GN. La sortie de chacun des amplificateurs Gi est connectée à une entrée d'un additionneur ADD. L'additionneur ADD fournit un signal de sortie s(t) par exemple à une antenne AT. Chacun des signaux Ve1 .. VeN définit une durée de consigne d'une des impulsions élémentaires e1 .. eN. Chaque impulsion élémentaire ei fournie par le générateur EPG est retardée par rapport à une impulsion élémentaire ei-1 fournie par une sortie précédente de la durée de cette dernière. Ainsi, à l'instant t0, le générateur EPG fournit sur une première sortie O1 une première impulsion e1 (t) de durée t1-t0. A l'instant t1, le générateur EPG fournit sur une seconde sortie 02 une seconde impulsion e2(t - t1 + t0) retardée de t1 - t0 par rapport à la première impulsion e1(t). A l'instant ti, le générateur EPG fournit sur une sortie Oi+1 une impulsion ei+1(t - ti + t0) retardée de ti - ti-1 par rapport à l'impulsion précédente ei et retardée de ti - t0 par rapport à l'impulsion e1(t).

Chaque impulsion élémentaire ei est ensuite amplifiée par l'un des amplificateurs Gi avec un gain défini par un signal de consigne d'amplitude Vai fourni en entrée de l'amplificateur. Les signaux de consigne Va1 .. VaN peuvent être positifs ou négatifs selon la polarité - positive ou négative - de l'impulsion élémentaire à générer. Les signaux de sortie AEi des amplificateurs Gi sont fournis en entrée de l'additionneur ADD.

Il est à noter que les impulsions élémentaires fournies par le générateur EPG peuvent être toutes de même signe, positif ou négatif, ou bien alternativement positives et négatives.

La figure 2a montre la forme du signal s(t) obtenu en sortie de l'additionneur ADD. La combinaison des impulsions élémentaires ei(t) réalisée par l'additionneur ADD forme un signal continu dans lequel les impulsions élémentaires amplifiées AEi se succèdent. Les impulsions élémentaires AEi constituant le signal s(t) peuvent être alternativement positives et négatives de manière à générer une forme d'onde passe-bande n'ayant pas de composante continue.

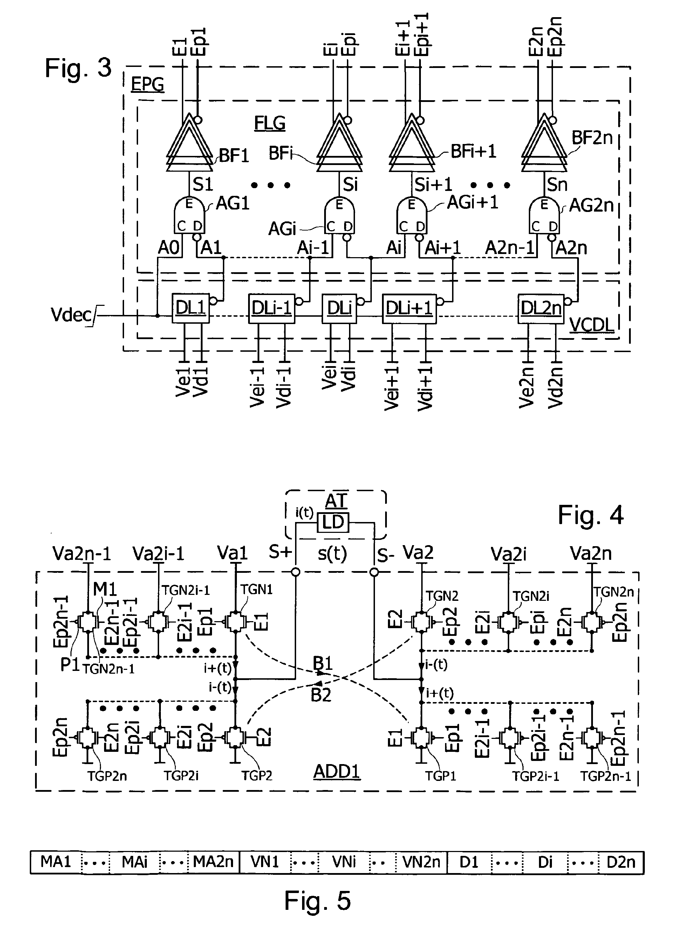

La figure 3 représente un mode de réalisation du générateur d'impulsions élémentaires EPG. Le générateur EPG comprend une ligne à retard variable VCDL commandée en tension, des portes logiques AG1, ... AGi, ... AG2n et des tampons de sortie BF1, ... BFi, ... BF2n. La ligne à retard VCDL comprend des cellules de retard DL1, ... DLi, ... DL2n montées en cascade. Chaque cellule DLi reçoit l'un des signaux de consigne de durée Vei. Une première cellule DL1 de la ligne à retard VCDL reçoit le signal de déclenchement Vdec, lequel est propagé dans les autres cellules DLi de la ligne à retard VCDL. Chaque cellule de retard DLi (i variant de 1 à 2n-1) fournit un signal Ai à une entrée D d'une porte AGi et à une entrée C d'une autre porte AGi+1. La cellule DL2n fournit un signal A2n à seulement la porte AG2n. Chaque porte AGi (i variant de 1 à 2n) combine les signaux Ai-1, Ai en sortie de deux cellules DLi-1, DLi consécutives de la ligne à retard VCDL, pour former une impulsion élémentaire numérique Si de durée égale à la valeur du retard appliqué par la cellule DLi, le signal A0 étant égal au signal Vdec. Chaque porte AGi comprend une sortie Si connectée à une entrée d'un tampon BFi. Chaque tampon BFi de type différentiel comprend deux sorties complémentaires fournissant deux signaux Ei, Epi à l'additionneur ADD, le signal Epi étant égal à la tension d'alimentation du circuit moins le signal Ei.

Chaque cellule DLi de la ligne VCDL peut en outre recevoir un signal d'inhibition Vdi permettant d'inhiber la cellule si celle-ci n'est pas utilisée, notamment afin de réduire la consommation électrique. Chaque porte AGi peut être une porte ET ou toute autre porte logique permettant de combiner deux fronts successifs pour former une impulsion élémentaire. Chaque tampon BFi peut comprendre plusieurs inverseurs en série pour réaliser une adaptation entre les tailles des transistors formant les portes AGi, qui sont petits et rapides, et des transistors plus gros (jusqu'à de l'ordre de 1000 fois plus gros) de portes de transmission de l'additionneur ADD, afin d'obtenir en sortie du tampon un courant suffisant pour commander les portes de transmission de l'additionneur.

La figure 4 représente un additionneur ADD1 selon un mode de réalisation. Sur la figure 4, l'additionneur ADD1 forme un pont en H à N = 2n branches pour fournir 2n impulsions élémentaires. L'additionneur ADD1 comprend n branches connectées à une sortie S+ et n branches connectées à une sortie S- de l'additionneur. Ainsi l'additionneur ADD1 comprend quatre groupes de n portes de transmission TGN1 à TGN2n, TGP1 à TGP2n montées en parallèle, chaque porte comprenant un transistor MOS à canal n M1 connecté en parallèle avec un transistor MOS à canal p P1. Le premier groupe comprend les portes de rang impair TGN1 à TGN2n-1 qui reçoivent d'un côté les tensions de consigne d'amplitude Va1 à Va2n-1 respectivement, et qui sont connectées de l'autre à la sortie S+ de l'additionneur ADD1. La grille de chacun des transistors M1 des portes TGN1 à TGN2n-1 reçoit respectivement l'un des signaux E1 à E2n-1 de rang impair, provenant du générateur EPG. La grille de chacun des transistors P1 des portes TGN1 à TGN2n-1 de rang impair, reçoit respectivement l'un des signaux Ep1 à Ep2n-1 de rang impair, provenant du générateur EPG. Le second groupe comprend les portes de transmission TGP2 à TGP2n de rang pair qui sont connectées d'un côté à la sortie S+, et de l'autre à la masse. La grille de chacun des transistors M1 des portes TGP2 à TGP2n de rang pair, reçoit respectivement les signaux E2 à E2n de rang pair, provenant du générateur EPG. La grille de chacun des transistors P1 des portes TGP2 à TGP2n de rang pair, reçoit respectivement les signaux Ep2 à Ep2n de rang pair. Le troisième groupe comprend les portes TGN2 à TGN2n de rang pair, qui reçoivent d'un côté les tensions de consigne d'amplitude Va2 à Va2n de rang pair, respectivement, et qui sont connectées de l'autre à la sortie S- de l'additionneur ADD1. La grille de chacun des transistors M1 des portes TGN2 à TGN2n reçoit respectivement les signaux E2 à E2n de rang pair, provenant du générateur EPG. La grille de chacun des transistors P1 des portes TGN2 à TGN2n reçoit respectivement les signaux Ep2 à Ep2n de rang pair, provenant du générateur EPG. Le quatrième groupe comprend les portes TGP1 à TGP2n-1 de rang impair qui sont connectées d'un côté à la sortie S-, et de l'autre à la masse. La grille de chacun des transistors M1 des portes TGP1 à TGP2n-1 de rang impair, reçoit respectivement les signaux E1 à E2n-1 de rang impair, provenant du générateur EPG. La grille des transistors P1 des portes TGP1 à TGP2n-1 de rang impair, reçoit respectivement les signaux Ep1 à Ep2n-1 de rang impair, provenant du générateur EPG. Les sorties S+, S- de l'additionneur ADD1 sont connectées à une charge LD formant l'antenne AT. Ainsi, la i ième branche de l'additionneur (i variant de 1 à 2n) est commandée par le signal Ei et son complément Eip et le signal qui la traverse est amplifié en fonction des tensions de consigne d'amplitude Vai.

Lorsqu'une impulsion élémentaire apparaît dans les signaux E2i-1 et Ep2i-1 (i variant de 0 à n), les portes TGN2i-1 et TGP2i-1 de la branche B2i-1 conduisent et un courant i+(t) proportionnel à la tension Va2i-1 traverse la charge LD de l'antenne AT, de la borne S+ vers la borne S-, produisant ainsi une impulsion élémentaire d'amplitude sensiblement égale ou proportionnelle à la tension de consigne Va2i-1. Ensuite, lorsqu'une impulsion élémentaire apparaît dans les signaux E2i et Ep2i (i variant de 1 à n), les portes TGN2i et TGP2i de la branche B2i conduisent et un courant i-(t) proportionnel à la tension Va2i et de polarité inverse au courant i+(t) traverse la charge LD, de la borne S- à la borne S+, produisant ainsi une impulsion élémentaire d'amplitude sensiblement égale ou proportionnelle à la tension de consigne Va2i, mais de polarité opposée à l'impulsion élémentaire précédente. De cette manière, des impulsions élémentaires de polarité alternativement positive et négative se succèdent dans la forme d'onde s(t). Chaque impulsion élémentaire du signal s(t) ayant la durée d'une impulsion élémentaire correspondante générée par le générateur EPG. La forme d'onde résultant de la combinaison de telles impulsions élémentaires présente un spectre passe-bande c'est-à-dire sans composante continue si la condition suivante est vérifiée :

$$\int_{t0}^{tN} s(t) \cdot dt = 0 \qquad\qquad (2)$$

L'additionneur ADD1 qui vient d'être décrit réalise donc à la fois une fonction de pondération (amplification) de chacune des impulsions élémentaires générées par le générateur EPG, et ce avec un gain qui peut être distinct du gain d'amplification des autres impulsions élémentaires, et une fonction de combinaison de ces impulsions élémentaires pour former la forme d'onde s(t).

La figure 5 représente la structure de données de commande du générateur PGN. Sur la figure 5, la structure de données comprend 2n mots MAi correspondant aux valeurs numériques des tensions de consigne d'amplitude Vai fixant l'amplitude de chaque impulsion élémentaire formant la forme d'onde s(t), 2n mots VNi correspondant aux valeurs numériques des tensions de consigne de durée Vei fixant la largeur de ces impulsions élémentaires, et 2n bits Di fixant la présence ou l'absence de chacune des tensions d'inhibition Vdi des cellules DLi. Le générateur PGN peut alors comprendre des convertisseurs numériques analogiques pour convertir ces mots en tensions Va1..Va2n, Ve1..Ve2n, Vd1..Vd2n.

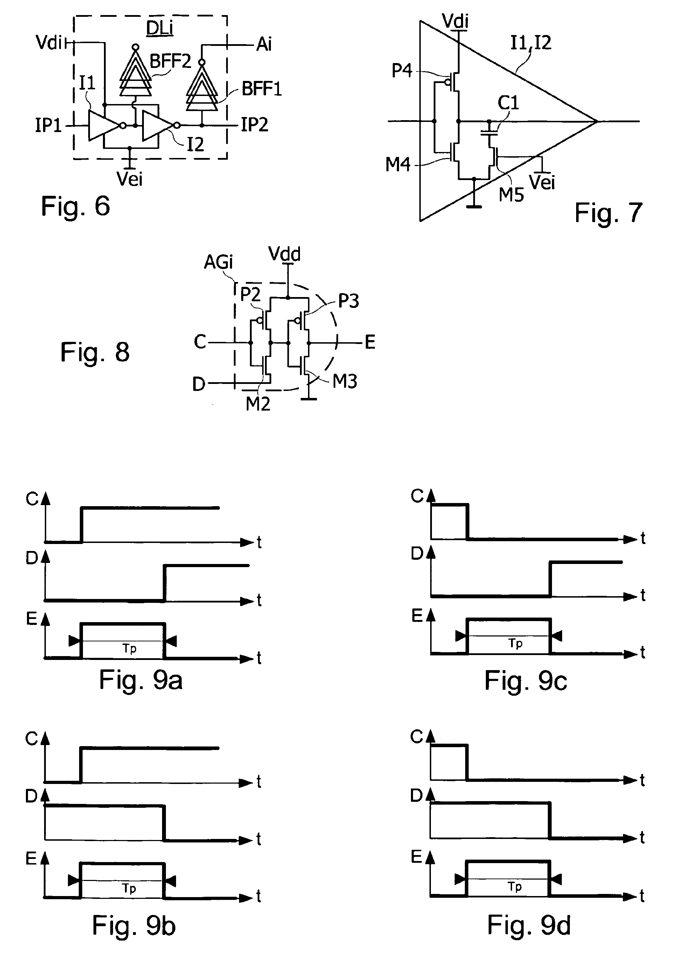

La figure 6 représente un mode de réalisation d'une cellule DLi de la ligne à retard VCDL. Chaque cellule DLi comprend deux inverseurs I1, 12 connectés en série, et un tampon inverseur BFF1. L'entrée de l'inverseur I1 est connectée à une entrée IP1 de la cellule DLi prévue pour recevoir le signal Vdec ou être connectée à une cellule précédente DLi-1 de la ligne à retard VCDL. La sortie de l'inverseur I1 est connectée à l'entrée du tampon BFF2 et à l'entrée de l'inverseur I2. La sortie de l'inverseur I2 est connectée à l'entrée du tampon BFF1 et à une sortie IP2 de la cellule DLi prévue pour être connectée à une cellule suivante DLi+1 de la ligne VCDL. La sortie du tampon BFF1 fournit le signal de sortie Ai de la cellule DLi. Ainsi, la cellule DLi fournit sur sa sortie IP1 le signal appliqué en entrée IP1, retardé d'une durée correspondant aux retards cumulés introduits par les inverseurs I1, 12. Un tampon BFF2 identique au tampon BFF1 peut être prévu pour équilibrer la charge des deux inverseurs I1, 12. Les deux inverseurs I1, I2 sont par ailleurs alimentés entre l'entrée du signal Vdi et l'entrée du signal Vei. Ainsi, si la tension d'inhibition Vdi est égale à la tension Vdd, la cellule DLi n'est pas alimentée et donc ne fonctionne pas.

La figure 7 représente un exemple de réalisation des inverseurs I1, 12. Chacun des inverseurs comprend deux transistors MOS à canal n M4, M5, un transistor MOS à canal p et un condensateur C1. Les transistors P4 et M4 sont connectés en série entre l'entrée de signal Vdi et la masse. Les grilles des deux transistors P4, M4 sont connectées à l'entrée de l'inverseur I1, 12. Les drains des transistors P4, M4 sont connectés à la sortie de l'inverseur I1, 12, ainsi qu'à la masse par l'intermédiaire du condensateur C1 en série avec le transistor M5. La grille du transistor M5 reçoit le signal Vei. Ainsi, la tension Vei module le courant dans la branche comprenant le transistor M5 et le condensateur C1, ce qui modifie le temps de propagation du signal dans l'inverseur I1, 12.

La figure 8 représente un exemple de réalisation des portes AGi. Sur la figure 8, chaque porte AGi comprend deux transistors MOS à canal P P2, P3 et deux transistors MOS à canal n M2, M3. Les transistors P2 et M2 sont montés en série entre la source d'alimentation Vdd du circuit et l'entrée D de la porte AGi. Les grilles des transistors P2 et M2 sont connectées à l'entrée C de la porte AGi. Les drains des transistors P2 et M2 sont connectés aux grilles des transistors P3, M3 qui sont connectés en série entre la source d'alimentation Vdd et la masse. Les drains des transistors P3 et M3 sont connectés à la sortie E de la porte AGi. Les transistors P2 et M2 réalisent ainsi la fonction logique (C inversé) OU D, et les transistors P3 et M3 forment un inverseur. La porte AGi réalise ainsi la fonction logique C ET (D inversé) pour former une impulsion élémentaire de largeur Tp entre un front montant dans le signal fourni à l'entrée C (Ai-1) et un front montant fourni à l'entrée D (Ai) de la porte AGi, comme illustré par les chronogrammes de la figure 9a.

D'autres types de portes AGi peuvent être prévus selon la combinaison de fronts à réaliser pour former les impulsions élémentaires, comme illustré par les chronogrammes des signaux C, D et E sur les figures 9a à 9d. Ainsi, sur la figure 9a, chaque porte AGi forme une impulsion élémentaire de durée Tp entre un front montant du signal C et un front montant du signal D. Chaque porte AGi réalise alors la fonction logique C ET (D inversé). Sur la figure 9b, chaque porte AGi forme une impulsion élémentaire de durée Tp entre un front montant du signal C et un front descendant du signal D. Chaque porte AGi réalise alors la fonction logique C ET D. Sur la figure 9c, chaque porte AGi forme une impulsion élémentaire entre un front descendant du signal C et un front montant du signal D. Chaque porte AGi réalise alors la fonction logique (C inversé) ET (D inversé), équivalente à la fonction logique (C OU D) inversé. Dans l'exemple de la figure 9d, chaque porte AGi forme une impulsion élémentaire entre un front descendant du signal C et un front descendant du signal D. Chaque porte AGi réalise alors la fonction logique (C inversé) ET D.

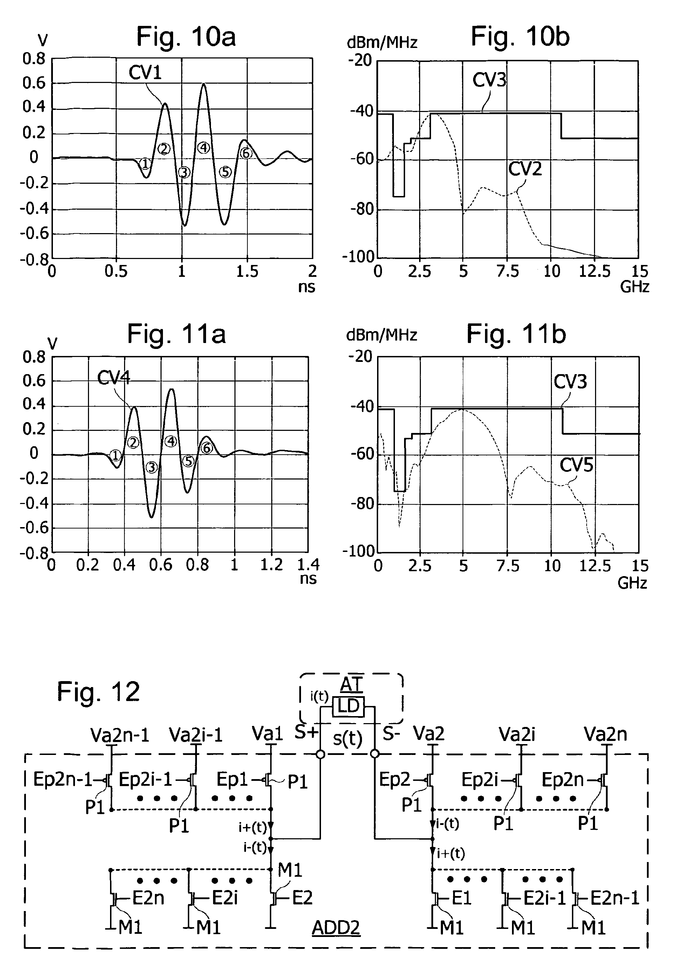

Les figures 10a, 10b, 11a, 11b sont des courbes illustrant le fonctionnement du générateur de forme d'onde. La figure 10a représente en fonction du temps une forme d'onde CV1 formée d'impulsions élémentaires générées et combinées par le générateur PGN. La figure 10b représente le spectre CV2 de la forme d'onde CV1 et un masque de transmission CV3, par exemple défini par une norme de transmission. Le masque de transmission définit en fonction de la fréquence, la densité spectrale de puissance moyenne en dBm/MHz maximum à ne pas dépasser par les signaux de transmission. Aux fréquences inférieures à 5 GHz, la densité spectrale de puissance moyenne CV2 est supérieure au masque CV3 et donc est supérieure à la limite autorisée. La figure 11a représente en fonction du temps des impulsions élémentaires CV4 générées et combinées par le générateur PGN. Les impulsions élémentaires de la courbe CV4 sont sensiblement identiques à celles de la courbe CV1 à l'exception de la cinquième impulsion élémentaire qui est légèrement atténuée (à environ -0.3 V sur la figure 11 a au lieu de -0.5 V sur la figure 10a). La figure 11 b représente le masque CV3 et le spectre CV5 de la forme d'onde CV4. Il apparaît sur la figure 11b que la modification de la cinquième impulsion élémentaire permet d'obtenir un spectre de forme d'onde CV5 situé sensiblement en dessous du masque CV3. Il peut également être noté que la largeur des impulsions élémentaires CV4 a été réduite par rapport à celle des impulsions élémentaires CV1, ce qui a eu pour effet d'élargir la bande passante de la forme d'onde CV4 (7,5 GHz environ dans le spectre CV5) par rapport à la forme d'onde CV1 (5 GHz environ dans le spectre CV2).

Dans l'additionneur ADD1 représenté sur la figure 4, l'utilisation de portes de transmission TGNj et TGPj (j variant de 1 à 2n) permet d'obtenir de bonnes performances en terme de dynamique du signal s(t) obtenu. Toutefois, d'autres portes de transmission peuvent être utilisées. Ainsi, la figure 12 représente un additionneur ADD2 selon un autre mode de réalisation. L'additionneur ADD2 diffère de l'additionneur ADD1 en ce que chacune des portes de transmission TGNj est remplacée par un simple transistor MOS à canal p P1 et chaque porte TGPj est remplacée par un simple transistor MOS à canal n M1. L'introduction de signaux de commande E1..E2n et Ep1..Ep2n dans l'additionneur ADD2 apparaît ainsi simplifiée par rapport à celle de l'additionneur ADD1. Toutefois, cette simplification entraîne une dissymétrie dans ces signaux de commande, et donc un risque d'apparition d'impulsions transitoires (glitches) qui peuvent détériorer la qualité de la forme d'onde dans le signal de sortie s(t).

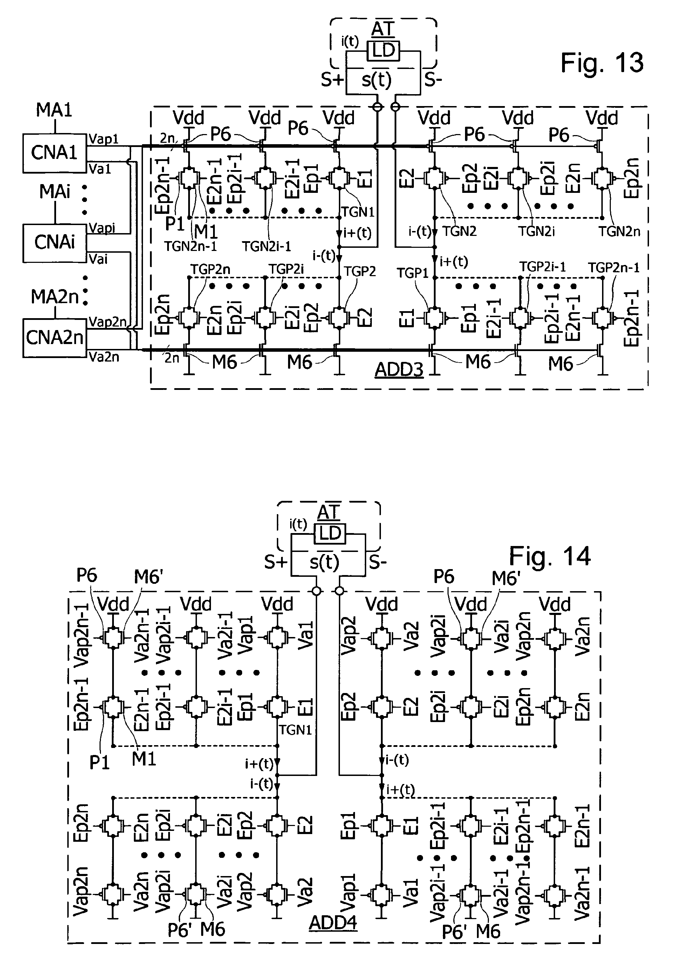

Les tensions de Vei, Vdi et Vai peuvent être fournies par des convertisseurs numériques analogiques recevant des commandes sous la forme de valeurs numériques. Toutefois, un courant important (plusieurs dizaines de mA) peut circuler dans les branches de l'additionneur ADD1, ADD2. Il en résulte que les tensions Vai ne peuvent généralement pas être fournies par des convertisseurs numériques analogiques standards. Afin de pouvoir utiliser des convertisseurs numériques analogiques standards pour générer les tensions de consigne d'amplitude Vai, l'additionneur peut être modifié conformément à la figure 13. Ainsi, la figure 13 représente un additionneur ADD3 qui diffère de l'additionneur ADD1 en ce que les tensions de consigne d'amplitude Vai sont fournies aux branches de l'additionneur sous forme différentielle par deux tensions complémentaires Vai, Vapi, par l'intermédiaire de transistors MOS P6, M6. Ainsi, les tensions de consigne d'amplitude Vapi (i variant de 1 à 2n) sont fournies aux grilles des transistors MOS à canal p P6 dont les sources reçoivent la tension d'alimentation Vdd du circuit, et les drains sont connectés respectivement aux portes de transmission TGNi. Les tensions de consigne d'amplitude Vai (i variant de 1 à 2n) sont fournies aux grilles des transistors MOS à canal n M6 dont les sources sont connectées à la masse, et les drains sont connectés respectivement aux portes de transmission TGPi. Chaque paire de tensions de consigne d'amplitudes complémentaires Vai et Vapi (i variant de 1 à 2n) est générée par un convertisseur numérique analogique CNAi recevant en entrée un mot de commande MAi, la tension Vapi étant égale à la tension d'alimentation du circuit Vdd moins la tension Vai.

De cette manière, le courant dans une branche de l'additionneur ADD3 est proportionnel à la tension Vai appliquée à la grille du transistor P6 de la branche et à la tension Vapi appliquée à la grille du transistor M6 de la branche. L'additionneur ADD3 peut ainsi être commandé à l'aide de convertisseurs numériques analogiques qui ne sont pas nécessairement dimensionnés pour fournir un courant important.

Afin d'augmenter la dynamique du signal de sortie, les transistors P6 et M6 peuvent être associés à un autre transistor M6' ou P6' de manière à former des portes de transmission. Ainsi, la figure 14 représente un additionneur ADD4 selon un autre mode de réalisation. L'additionneur ADD4 diffère de l'additionneur ADD3 en ce que les transistors P6 et M6 sont remplacés par des portes de transmission comprenant chacune un transistor P6 recevant sur sa grille la tension de consigne d'amplitude Vapi et un transistor M6 recevant sur sa grille la tension de consigne d'amplitude Vai. D'autres modes de réalisation de l'additionneur peuvent être envisagés en remplaçant seulement les transistors M6 ou seulement les transistors P6 de l'additionneur ADD3 par des portes de transmission.

Afin de réaliser des modulations bipolaires ou biphase, le générateur PGN qui vient d'être décrit peut générer des formes d'onde bipolaires ou de polarités inverses l'une de l'autre, c'est-à-dire comprenant un même nombre d'impulsions élémentaires, chaque impulsion élémentaire dans l'une des formes d'onde ayant la même amplitude et une polarité opposée à l'impulsion élémentaire de même rang dans l'autre forme d'onde. La forme d'onde dite "positive" commence par une impulsion élémentaire positive et la forme d'onde dite "négative" commence par une impulsion élémentaire négative. A cet effet, les tensions de commande des impulsions élémentaires positives et celles des impulsions élémentaires négatives doivent être décalées d'une branche de l'additionneur. Ainsi, une forme d'onde positive est générée en appliquant successivement la tension de consigne d'amplitude Va1 sur la branche B1, Va2 sur la branche B2, puis généralement, Vai sur la branche Bi, et enfin Van sur la branche B2n. Pour générer une forme d'onde négative, une tension de consigne d'amplitude de 0 V est introduite dans la branche B1, puis la tension Va1 est appliquée à la branche B2, puis plus généralement, la tension de consigne d'amplitude Vai est appliquée sur la branche Bi+1. Ainsi la génération d'une forme d'onde négative introduit un retard égal au retard t1-t0 correspondant à la première impulsion élémentaire à 0 V générée par la première branche B1 de l'additionneur.

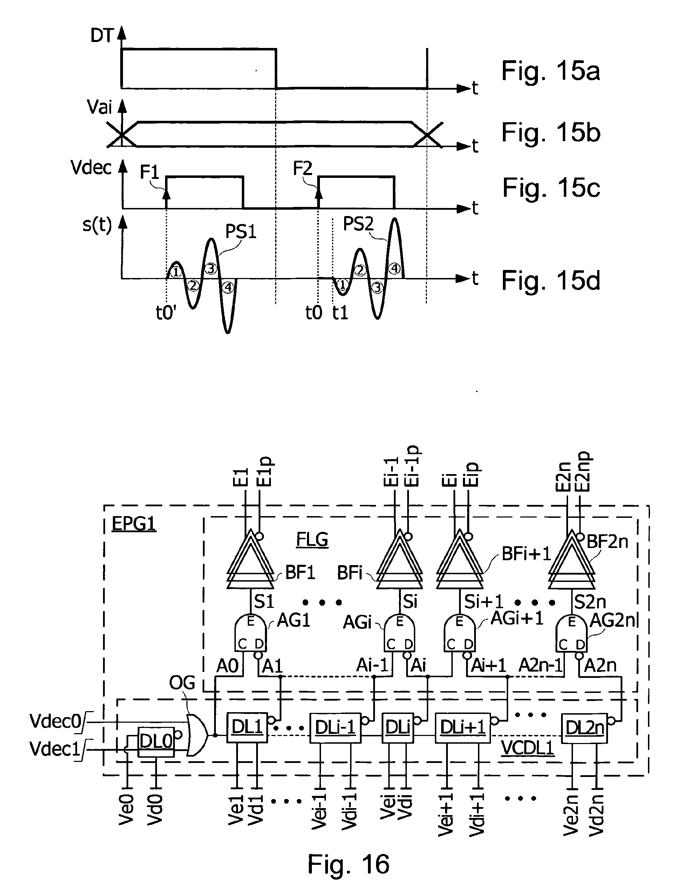

Les figures 15a à 15d représentent des chronogrammes de signaux du générateur PGN illustrant la génération de formes d'onde bipolaires. La figure 15a représente un signal numérique de données DT à transmettre comprenant un 1 suivi d'un 0. La figure 15b représente un signal de consigne d'amplitude Vai en sortie d'un des convertisseurs numériques analogiques CNAi. La figure 15c représente le signal de déclenchement Vdec et la figure 15d représente le signal s(t) en sortie de l'additionneur. Le signal Vdec comporte deux fronts montants F1, F2 à t0' et t0 qui déclenchent chacun la génération d'une forme d'onde PS1, PS2 composée d'une séquence de 4 impulsions élémentaires. Les formes d'onde PS1 et PS2 sont en opposition de phase, la forme d'onde PS1 étant positive (commençant par une impulsion élémentaire positive) pour transmettre la donnée à 1 du signal DT. La forme d'onde PS2 est négative (commençant par une impulsion élémentaire négative) pour transmettre la donnée à 0 du signal DT. La forme d'onde PS2 n'est générée qu'à partir de l'instant t1 après t0, à l'activation de la seconde branche B2 de l'additionneur.

La figure 16 représente un générateur d'impulsions élémentaires EPG1 selon un autre mode de réalisation. Le générateur EPG1 est modifié afin de supprimer le décalage temporel t0-t1 qui peut induire des raies dans le spectre des formes d'onde générées et qui peut dégrader la qualité du signal. A cet effet, le circuit EPG1 diffère du circuit EPG en ce qu'il comporte une entrée de signal de déclenchement modifiée pour retarder de t1-t0 la génération des formes d'onde positives par rapport aux formes d'onde négatives. Ainsi, le générateur EPG1 comporte une entrée de signal de déclenchement Vdec1 pour déclencher la génération d'une forme d'onde positive et une entrée de signal de déclenchement Vdec0 pour déclencher la génération d'une forme d'onde négative. Le générateur EPG1 comprend également une cellule de retard supplémentaire DL0 recevant le signal de déclenchement Vdec1, un signal de consigne de durée Ve0 et un signal de commande d'inhibition Vd0. La sortie IP2 (figure 6) de la cellule DL0 est connectée à une entrée d'une porte logique OG de type OU dont une autre entrée reçoit le signal de déclenchement Vdec0. La sortie de la porte OG est connectée à l'entrée IP1 (figure 6) de la cellule DL1. Les signaux Vdec0 et Vdec1 correspondent par exemple à des signaux de commande d'émission d'une donnée binaire DT à 0 et à 1.

Lorsqu'une forme d'onde de polarité positive doit être générée, le signal de consigne de durée Ve0 est égal au signal Ve1 de la première impulsion élémentaire de la forme d'onde et une impulsion de déclenchement apparaît dans le signal Vdec1. Les cellules DL0 et DL1 reçoivent le signal de consigne de durée Ve1 et plus généralement, la cellule DLi reçoit le signal de consigne de durée Vei. Par ailleurs, la branche B1 de l'additionneur reçoit le signal de consigne d'amplitude Va1 (ou Va1 et Vap1) et plus généralement la branche Bi de l'additionneur reçoit le signal de consigne d'amplitude Vai (ou Vai et Vapi). Lorsqu'une forme d'onde négative doit être générée, une impulsion de déclenchement apparaît dans le signal Vdec0. Les cellules DL1 et DL2 reçoivent le signal de consigne de durée Ve1, et plus généralement, les cellules DLi reçoivent le signal de consigne de durée Vei-1. Par ailleurs, la branche B1 de l'additionneur reçoit un signal de consigne d'amplitude à 0 V. La branche B2 de l'additionneur reçoit le signal de consigne d'amplitude Va1 (ou Va1 et Vap1), et plus généralement la branche Bi+1 de l'additionneur reçoit le signal de consigne d'amplitude Vai (ou Vai et Vapi). De cette manière, le retard initial avec lequel les formes d'onde positives sont générées est égal au retard initial nécessaire à la génération des formes d'onde négatives.

Le générateur EPG1 peut alors comprendre un ensemble supplémentaire (ou davantage) d'une cellule de retard DL2n+1, d'une porte AG2n+1 et d'un tampon BF2n+1. Lors de la génération d'une forme d'onde négative, la cellule de retard DL2n+1 reçoit le signal Ve2n et le tampon BF2n+1 fournit des signaux E2n+1 et EP2n+1. De même l'additionneur peut comprendre une branche supplémentaire B2n+1 (ou davantage) recevant les signaux de consigne d'amplitude Va2n (ou Va2n et Vap2n), ainsi que les signaux E2n+1 et EP2n+1, lors de la génération d'une forme d'onde négative.

Il est à noter que le générateur EPG, EPG1 ne comporte pas nécessairement un nombre de sorties pair et l'additionneur ADD, ADD1, ADD2, ADD3, ADD4 ne comporte pas nécessairement un nombre de branches pair, ces nombres pouvant également être impairs, étant donné que les formes d'onde générées ne comportent pas nécessairement un nombre pair d'impulsions élémentaires. Dans ce cas, l'additionneur peut comporter une branche impaire de plus que les branches paires. Toutefois, le nombre de branches paires peut être maintenu égal au nombre de branches impaires afin d'équilibrer les charges. Les branches inutilisées peuvent être commandées en leur appliquant un signal Vai à 0.

Le générateur de forme d'onde PGN qui vient d'être décrit présente une limitation en termes de nombre maximal d'impulsions élémentaires qu'il peut combiner pour générer une forme d'onde. Cette limitation résulte de la longueur des connexions entre les branches de l'additionneur ADD, ADD1-ADD4 et les noeuds S+ et S-. La longueur de ces interconnexions est proportionnelle au nombre de branches de l'additionneur, correspondant au nombre d'impulsions élémentaires maximum à combiner. La longueur de ces interconnexions limite la fréquence maximale des impulsions susceptibles d'être produites par le générateur EPG. Or plus la bande passante des formes d'onde à générer est étroite, plus le nombre d'impulsions élémentaires nécessaires à leur génération est élevé. Il s'avère que le nombre minimum Nm d'impulsions élémentaires nécessaires pour générer une forme d'onde s(t) dépend de la fréquence centrale f0 de la forme d'onde et de la bande passante BW de cette dernière conformément à l'équation suivante :

$$Nm \approx \frac{4 \cdot f0}{BW} \qquad\qquad (2)$$

Quelques exemples de valeurs de f0, BW et Nm sont donnés dans le tableau 3 suivant :

Tableau 3

| f0 | 3.35 | 3.75 | 3.75 | 3.75 | 4 | 7 | 8 |
|----|------|------|------|------|---|---|---|
| BW | 0.5 | 0.5 | 0.75 | 1 | 2 | 7 | 0.5 |
| Nm | 26.8 | 30 | 20 | 15 | 8 | 4 | 64 |

Ainsi, pour générer une forme d'onde de BW = 500 MHz de large centrée sur une fréquence f0 = 8 GHz, il faut combiner au minimum Nm = 64 impulsions élémentaires.

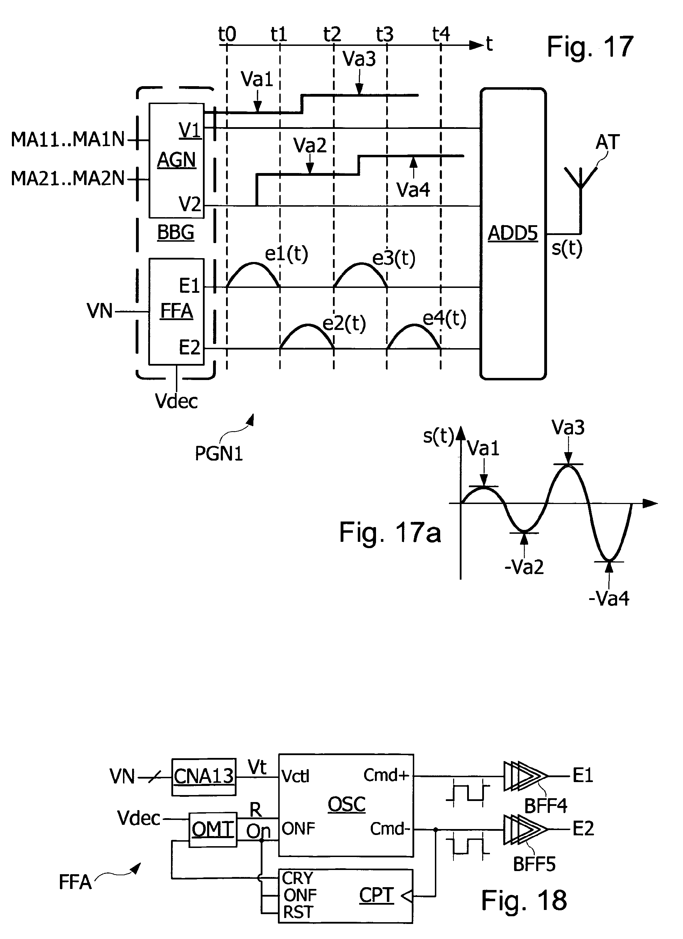

La figure 17 représente un générateur PGN1 selon un autre mode de réalisation. Le générateur PGN1 comprend un générateur d'impulsions élémentaires BBG et un additionneur ADD5 fournissant un signal s(t) à une antenne AT. Le générateur BBG comprend un circuit de génération d'impulsions élémentaires FFA recevant un signal de déclenchement Vdec et un mot de commande VN. Le circuit FFA est configuré pour fournir un train d'impulsions élémentaires impaires e1(t), e3(t), ... sur une sortie E1, et un train d'impulsions élémentaires paires e2(t), e4(t), ... sur une sortie E2, les impulsions élémentaires présentant une amplitude sensiblement fixe et apparaissant alternativement dans les deux trains d'impulsions à une fréquence fixe définie par un mot de commande VN. Le générateur BBG comprend également un circuit de génération de tensions de commande AGN recevant une première série de N mots de commande MA11 à MA1N définissant respectivement des amplitudes de consigne des impulsions élémentaires impaires ou positives à générer successivement, et une seconde série de N mots de commande MA21 à MA2N définissant respectivement des amplitudes de consigne des impulsions élémentaires paires ou négatives à générer successivement. Le circuit AGN est configuré pour fournir sur deux sorties V1, V2, des tensions correspondant aux amplitudes des impulsions élémentaires fournies par le circuit FFA. A tout instant, le signal V1 définit l'amplitude d'une impulsion élémentaire courante apparaissant à la sortie E1, et le signal V2 définit l'amplitude d'une impulsion élémentaire courante apparaissant à la sortie E2. Les sorties E1, E2, V1, V2 sont connectées à l'additionneur ADD5. Ainsi l'additionneur ADD5 reçoit en même temps une impulsion élémentaire par l'une des sorties E1, E2 et l'amplitude de cette impulsion par la sortie V1 ou V2 correspondante.

A un instant t0, le circuit AGN reçoit le signal de déclenchement Vdec et fournit sur la sortie V1 un signal à la tension Va1 correspondant au mot de commande MA11, et le circuit FFA fournit sur la sortie E1 une impulsion e1(t) de durée t1-t0. Entre les instants t0 et t1, le circuit AGN fait passer la tension à la sortie V2 à Va2 correspondant au mot de commande MA21. A l'instant t1, le circuit FFA fournit sur la sortie E2 une impulsion e2(t) de durée t2-t1. Entre les instants t1 et t2, le circuit AGN fournit sur la sortie V1 un signal à la tension Va3 correspondant au mot de commande MA12. A l'instant t2, le circuit FFA fournit sur la sortie E1 une impulsion e3(t) de durée t3-t2. Entre les instants t2 et t3, le circuit AGN fait passer la tension à la sortie V2 à une tension Va4 correspondant au mot de commande MA22. A l'instant t3, le circuit FFA fournit sur la sortie E2 une impulsion e4(t) de durée t4-t3. L'additionneur ADD5 reçoit et combine les signaux V1, V2, E1, E2 de manière à fournir une forme d'onde s(t) comprenant successivement les impulsions e1, e2, e3 et e4 qui présentent une même durée correspondant au mot de commande VN, et des amplitudes respectives Va1, -Va2, Va3 et -Va4, comme illustré sur la figure 17a qui représente un chronogramme du signal s(t). En d'autres termes, l'additionneur ADD5 combine les signaux de V1, E1 de manière à fournir les impulsions élémentaires positives, impaires e1, e3 dans la forme d'onde s(t), et combine les signaux de sortie V2, E2 de manière à fournir des impulsions élémentaires négatives ou paires e2, e4 dans la forme d'onde s(t).

Il est à noter que le nombre d'impulsions élémentaires impaires composant la forme d'onde n'est pas nécessairement égal au nombre d'impulsions élémentaires paires, et peut être égal à N+1 tandis que le nombre d'impulsions élémentaires paires est égal à N.

La figure 18 représente le circuit de génération d'impulsions élémentaires FFA, selon un mode de réalisation. Le circuit FFA comprend un convertisseur numérique analogique CNA13, un oscillateur OSC par exemple du type oscillateur contrôlé en tension (Voltage Controlled Oscillator) à sortie différentielle, un circuit de comptage CPT et un circuit de gestion de déclenchement OMT. Le convertisseur CNA13 reçoit un mot de commande de tension VN et fournit en sortie une tension de commande Vt à une entrée de commande Vctl de la fréquence de l'oscillateur OSC. Le circuit OMT comprend une entrée recevant le signal de déclenchement Vdec et deux sorties fournissant à l'oscillateur OSC un signal d'initialisation R et un signal de commande de marche/arrêt ON. L'oscillateur OSC comprend deux sorties complémentaires Cmd-, Cmd+ connectées chacune à un tampon BFF4, BBF5. Le signal à la sortie Cmd- est égal à la tension d'alimentation du circuit Vdd moins le signal à la sortie Cmd+. Les signaux aux sorties Cmd- et Cmd+ sont donc en opposition de phase. Les tampons BFF4, BFF5 fournissent les signaux E1, E2. Les signaux E1 et E2 sont donc également en opposition de phase. Chaque tampon BFF4, BFF5 peut comprendre plusieurs inverseurs en série pour réaliser une adaptation entre les tailles des transistors formant l'oscillateur OSC et des transistors plus gros (jusqu'à de l'ordre de 1000 fois plus gros) de portes de transmission formant l'additionneur ADD5, afin d'obtenir en sortie du tampon un courant suffisant pour commander les portes de transmission de l'additionneur. Le compteur CPT est cadencé par l'un ou l'autre des signaux E1, E2, par exemple le signal E2, et comprend une entrée de déclenchement ONF et une entrée d'initialisation RST recevant toutes deux le signal ON en sortie du circuit OMT. Le compteur CPT fournit un signal de retenue CRY au circuit OMT lorsqu'il atteint un nombre maximum et revient à 0. La valeur du compteur CPT est fixé à N, 2N étant le nombre d'impulsions élémentaires à générer. Le circuit OMT comprend par exemple une porte logique recevant en entrée les signaux Vdec et CRY et fournissant le signal ON par exemple égal à Vdec ET (CRY inversé). Le signal R peut être généré à partir du signal CRY et de lignes à retard définissant un premier retard entre l'apparition du signal CRY et la mise à 1 du signal R et un second retard définissant la durée pendant laquelle le signal R reste à 1.

Il est à noter que l'ensemble formé par l'oscillateur OSC et le convertisseur CNA13 peut être remplacé par un oscillateur contrôlé numériquement NCO.

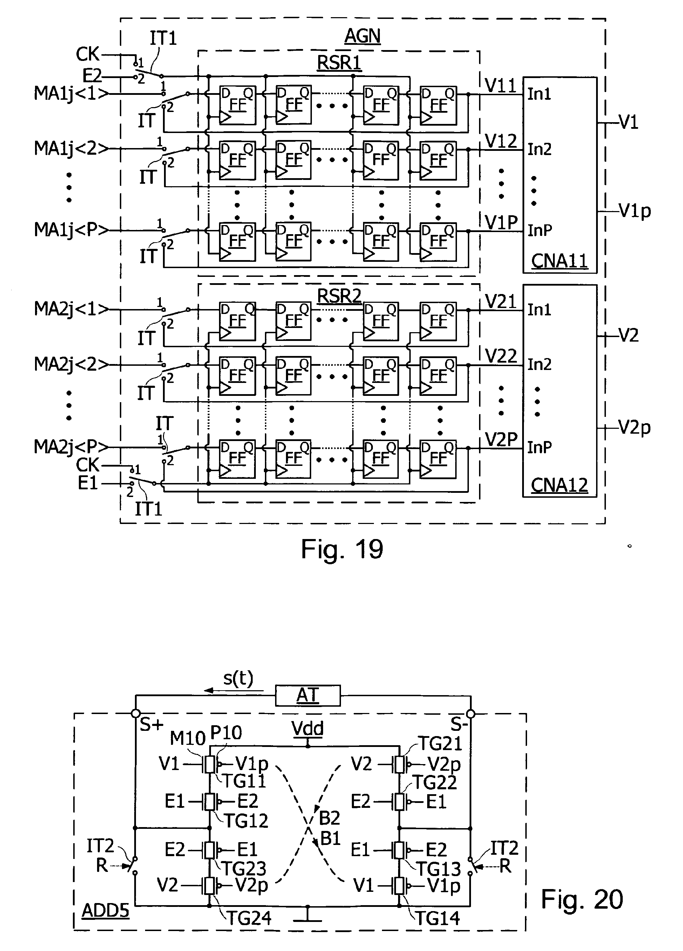

La figure 19 représente le circuit de génération de tensions AGN, selon un mode de réalisation. Le circuit AGN reçoit en entrée les bits 1 à P des N mots de commande MA11 à MA1N et des N mots de commande MA21 à MA2P. Le circuit AGN comprend deux ensembles RSR1, RSR2 de P registres à décalages, et deux convertisseurs numériques analogiques CNA11, CN12. Chaque registre à décalage comprend N bascules FF par exemple de type bascule D. Chaque ensemble RSR1, RSR2 reçoit en entrée par l'intermédiaire d'interrupteurs IT (un interrupteur par registre à décalage) les bits (de 1 à P) successivement des mots MA11..MA1N ou MA21..MA2N. La série de mots MA11..MA1N introduits dans l'ensemble RSR1 fixe les amplitudes de N impulsions élémentaires impaires ou positives, et la série de mots MA21..MA2N introduits dans l'ensemble RSR2 fixe les amplitudes de N impulsions élémentaires paires ou négatives. Les sorties V11 à V1P ou V21 à V2P de chacun des deux ensembles de registres RSR1, RSR2 sont connectées à une borne des interrupteurs IT et à des entrées IN1 à INP d'un des deux convertisseurs CNA11, CNA12. Les bascules FF de l'ensemble de registres à décalage RSR1 recevant les mots de commande MA1j sont cadencées soit par un signal d'horloge CK, soit par le signal E2 en sortie du circuit FFA, le signal cadençant les bascules étant sélectionné par un interrupteur IT1. Les bascules FF de l'ensemble de registres à décalage RSR2 recevant les mots de commande M2j sont cadencées soit par le signal d'horloge CK, soit par le signal E1 en sortie du circuit FFA, sélectionné par un interrupteur IT1. Le nombre de bascules FF des registres à décalage de chacun des ensembles RSR1, RSR2 correspond au nombre maximum d'impulsions élémentaires respectivement impaires et paires à générer pour former la forme d'onde s(t).

Le convertisseur CNA11 de type différentiel comprend deux sorties fournissant des tensions complémentaires V1, V1p. La tension V1 correspond à la valeur numérique définie par les bits V11..V1P et la tension V1 p est égale à la tension d'alimentation du circuit Vdd moins la tension V1. Le convertisseur CNA12 également de type différentiel, comprend deux sorties fournissant des tensions complémentaires V2, V2p. La tension V2 correspond à la valeur numérique définie par les bits V21..V2P et la tension V2p est égale à la tension d'alimentation du circuit Vdd moins la tension V2.

Pendant une phase d'initialisation, les interrupteurs IT, IT1 sont en position 1 pour charger les registres à décalage RSR1, RSR2 avec les bits (de 1 à P) des deux séries de N mots de commande MA11 à MA1N et MA21 à MA2N à une fréquence d'horloge CK quelconque. A la fin de la phase d'initialisation, les registres à décalage RSR1, RSR2 contiennent toutes les valeurs numériques des amplitudes des impulsions élémentaires à générer pour former une forme d'onde. Dans une phase d'exploitation, les interrupteurs IT, IT1 sont en position 2 de manière à reboucler la sortie sur l'entrée des registres à décalage, et à cadencer ces deniers par les signaux E1, E2. A l'issue de N fronts descendants dans chacun des signaux E1, E2, 2N impulsions élémentaires ont été générées et les registres à décalage sont revenus à leurs valeurs initiales, prêts pour générer une autre forme d'onde identique dans le signal s(t). Ainsi durant la phase d'exploitation, le signal V1 est égal successivement aux amplitudes de consigne Va1, Va3, ... Va2i-1, ... des impulsions impaires, et change de valeur à chaque front montant du signal E1. De même, le signal V2 est égal successivement aux amplitudes de consigne Va2, Va4, ... Va2i, ... des impulsions paires, et change de valeur à chaque front montant du signal E2.

La figure 20 représente l'additionneur ADD5, selon un mode de réalisation. L'additionneur ADD5 comprend un pont en H à deux branches, soit quatre demi branches dont deux sont connectées entre la source de tension d'alimentation Vdd et des bornes S+, S- de connexion avec l'antenne AT, et deux sont connectées entre les bornes S+, S- et la masse. Chaque demi branche comprend deux portes de transmission TG11 à TG14 et TG21 à TG24 connectées en série, chaque porte comportant un transistor MOS à canal p P10 et un transistor MOS à canal n M10. Les bornes S+ et S-sont également reliées à la masse par l'intermédiaire d'interrupteurs IT2 commandés par le signal R.

Une première demi branche comprenant les portes TG11 et TG12 en série est connectée entre la source de tension d'alimentation Vdd et la borne S+ de l'antenne AT. Une seconde demi branche comprenant les portes TG13 et TG14 en série est connectée entre la borne S- et la masse. Le transistor M10 des portes TG12 et TG13 reçoit sur sa grille la tension E1, et le transistor P10 des portes TG12 et TG13 reçoit sur sa grille la tension E2. Le transistor M10 des portes TG11 et TG14 reçoit sur sa grille la tension V1, et le transistor P10 des portes TG11 et TG14 reçoit sur sa grille la tension V1 p. Une troisième demi branche comprenant les portes TG21 et TG22 en série est connectée entre la source de tension d'alimentation Vdd et la borne S-. Une quatrième demi branche comprenant les portes TG23 et TG24 en série est connectée entre la borne S+ et la masse. Le transistor M10 des portes TG22 et TG23 reçoit sur sa grille la tension E2, et le transistor P10 des portes TG22 et TG23 reçoit sur sa grille la tension E1. Le transistor M10 des portes TG21 et TG24 reçoit sur sa grille la tension V2, et le transistor P10 des portes TG21 et TG24 reçoit sur sa grille la tension V2p. Les première et seconde demi branches forment une branche B1 qui conduit lorsque les signaux V1 et E1 sont voisins de la tension d'alimentation Vdd et lorsque les signaux V1 p et E2 voisins de 0 V. Les troisième et quatrième demi branches forment une branche B2 qui conduit lorsque les signaux V2 et E2 sont voisins de la tension d'alimentation Vdd et lorsque les signaux V2p et E1 voisins de 0 V. Comme les signaux E1 et E2 sont en opposition de phase, la durée des impulsions élémentaires en sortie de l'additionneur ADD5 est donc égale à la moitié de la période d'oscillation de l'oscillateur OSC. Par ailleurs, comme les registres à décalage RSR1, RSR2 sont cadencés par les signaux E1 et E2, les signaux V1, V1p sont synchrones avec le signal E1, et les signaux V2, V2p sont synchrones avec le signal E2. Les signaux V1, V1 p, V2, V2p définissent l'amplitude des impulsions élémentaires générées dans la forme d'onde s(t) et les signaux E1, E2 définissent la durée de ces impulsions.

A la fin de la génération d'une forme d'onde dans le signal s(t), le signal R commande la fermeture des interrupteurs IT2 pour décharger le pont en H de l'additionneur ADD5. Le signal R est tel qu'il ferme les interrupteurs IT2 quelques instants après l'arrêt de l'oscillateur OSC pour tenir compte de temps de propagation des signaux dans les circuits du générateur PGN1.

Il est à noter que l'additionneur peut être également du type représenté sur la figure 4 avec seulement deux branches recevant les tensions V1 et V2 et une porte de transmission par demi branche recevant les signaux E1, E1 p ou E2, E2p.

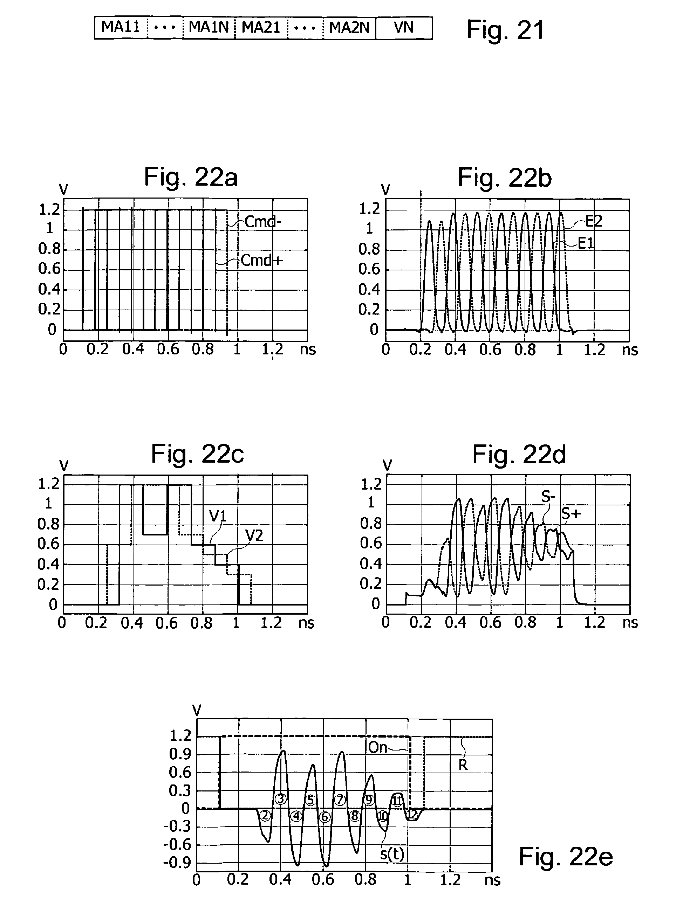

La figure 21 représente la structure de données de commande du générateur PGN1. Les données de commande du générateur PGN1 comprennent les séries de mots de commande MA11 à MA1N, MA21 à MA2N fixant les amplitudes des N impulsions élémentaires impaires et des N impulsions élémentaires paires générées dans le signal résultant s(t), et le mot de commande VN fixant la durée de ces 2N impulsions élémentaires.

Les figures 22a à 22e représentent des courbes de variation en fonction du temps de différentes tensions dans le générateur PGN1. Ces courbes ont été obtenues avec des séries de mots de commande MA11 à MA16 et MA21 à MA26 tels qu'ils définissent des amplitudes de consigne respectives égales à 0, 0.6, 1.2, 1.2, 0.7, 1.2, 1.2, 0.7, 0.6, 0.5, 0.4 et 0.3 pour douze impulsions élémentaires, les mots MA11..MA16 définissant les amplitudes des impulsions élémentaires impaires, et les mots MA21..MA26 définissant les amplitudes des impulsions élémentaires paires. La figure 22a représente des courbes de variation des tensions des signaux commande Cmd+ et Cmd-. Les signaux Cmd+, Cmd-comportent chacun un train de six impulsions de mêmes amplitudes et présentant la forme d'un signal carré positif et dont la durée est égale à environ 70 ps. Durant ces trains d'impulsions, les signaux Cmd+ et Cmd- sont en opposition de phase.

La figure 22b représente des courbes de variation des tensions des signaux E1, E2. Les signaux E1, E2 comportent chacun un train de six impulsions sensiblement de même amplitude (à 10% près) et sont en opposition de phase. Les impulsions du signal E1 sont sensiblement synchrones des impulsions du signal Cmd+ à environ une demi période près du signal Cmd+ ou Cmd-, ce retard étant dû au temps de propagation des signaux dans les inverseurs. La forme des impulsions des signaux E1, E2 est arrondie par rapport aux signaux Cmd+ et Cmd- en raison de la présence des tampons BFF4, BFF5.

La figure 22c représente des courbes de variation des tensions des signaux V1, V2. Les signaux V1, V2 comportent chacun une séquence de six échelons de tension, ces deux signaux étant décalés l'un par rapport à l'autre d'environ une demi période du signal Cmd+ ou Cmd-. La figure 22d représente la forme des signaux S+ et S- aux bornes de sortie de l'additionneur ADD5. Les signaux S+ et S- comportent chacun un train d'impulsions positives d'amplitude variable et décalés l'un par rapport à l'autre d'une demi période du signal Cmd+ ou Cmd-. La figure 22e représente les signaux R, ON et s(t). Le signal ON est à 0 V sauf pendant la période où des impulsions sont présentes dans les signaux Cmd- et Cmd+ où il est à la tension Vdd. Le signal R est à 0 V pendant la période où le signal ON est à Vdd, et passe à Vdd pendant une certaine durée lorsque le signal ON est à 0 V. Le signal s(t) comporte une séquence d'impulsions comportant des impulsions correspondant en durée et en amplitude aux impulsions du signal S+, et des impulsions correspondant en durée et en amplitude aux impulsions du signal S- mais inversées.

Le signal R ouvre les interrupteurs IT2, puis le signal ON passe à 1. L'oscillateur OSC démarre et commence à fournir des signaux Cmd+, Cmd-non nuls. Parallèlement, les registres à décalage RSR1, RSR2 fournissent des tensions V1, V2, V1P, V2P non nulles en même temps que des impulsions élémentaires sont générées dans les signaux E1, E2. Après la génération des douze impulsions élémentaires, le compteur CPT fournit un signal de fin de comptage CRY qui déclenche le passage à 0 du signal ON et donc l'arrêt de l'oscillateur OSC. Quelques instants après correspondant au temps de propagation des impulsions dans les circuits, le signal R passe à 1 pour commander les interrupteurs IT2 et ainsi décharger le pont en H de l'additionneur ADD5.

Il peut être noté sur la figure 22e que le signal s(t) obtenu comporte onze impulsions élémentaires (la première impulsion élémentaire ayant une amplitude de consigne égale à 0), alternativement négatives et positives, et ayant des amplitudes sensiblement égales à celles mentionnées précédemment. L'écart d'amplitude qui peut être constaté entre les amplitudes de consigne et les amplitudes obtenues n'est pas strictement linéaire. Il peut être constaté que ces non linéarités sont d'autant plus importantes que le générateur fonctionne à fréquence élevée (supérieure à 3 GHz), mais peuvent être réduites en utilisant une technologie de fabrication de circuits intégrés plus performante. Par ailleurs, la possibilité d'agir sur l'amplitude de chaque impulsion élémentaire peut être mise à profit pour compenser ces non linéarités, sans pénaliser le fonctionnement du générateur. Cette possibilité peut également être mise à profit pour compenser des variations de caractéristiques de fonctionnement du circuit intégré dans lequel est réalisé le générateur, résultant de variations PVT (conditions de fabrication du circuit, tension d'alimentation du circuit, température ambiante de fonctionnement du circuit).

Il est à noter que l'additionneur peut comporter davantage de branches, par exemple 4 ou 6, ou plus généralement B branches. Si l'additionneur comprend B branches, le circuit AGN peut comporter B ensembles de registres à décalage recevant B ensembles de mots de commande MA11..MA1N à MAB1..MABN, et autant de convertisseurs analogiques numériques CNA11 à CNA1B fournissant des paires de tensions complémentaires V1, V1P à VB, VBp. La fréquence de l'oscillateur OSC est alors ajustée à 1/(B·Tp), Tp étant la durée des impulsions élémentaires. L'oscillateur fournit B signaux E1 à EB ayant des phases uniformément réparties sur une période de l'oscillateur.

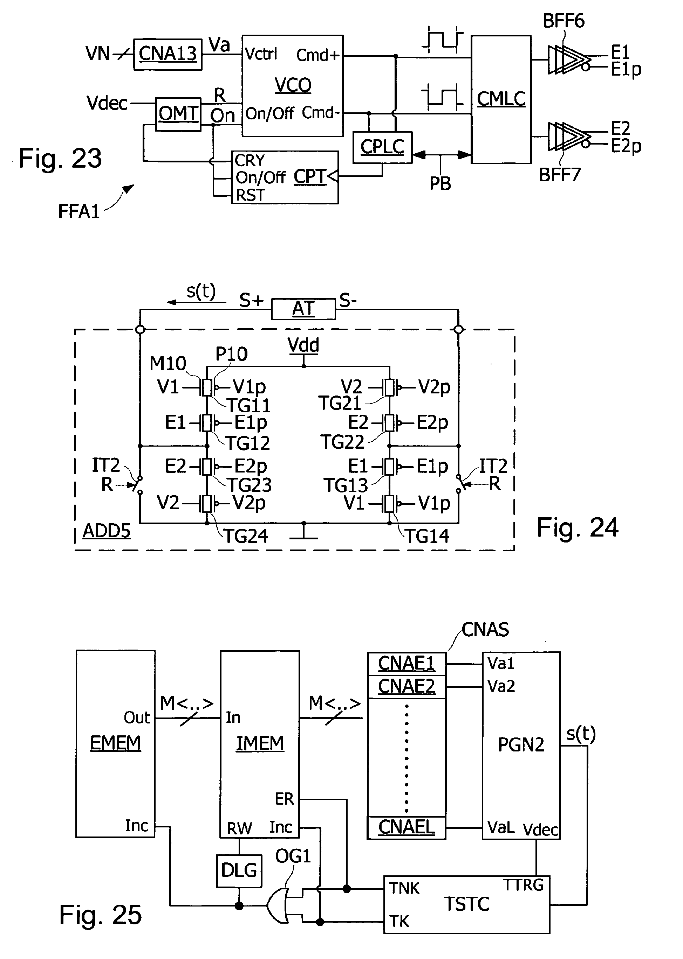

Afin de générer des formes d'onde bipolaires dans le signal s(t), c'est-à-dire commençant successivement et alternativement par une impulsion élémentaire positive et négative, le générateur PGN1 peut être modifié pour que la première impulsion élémentaire puisse être au choix générée dans la branche B1 ou la branche B2 de l'additionneur ADD5. A cet effet, le générateur PGN1 comporte un circuit de génération d'impulsions élémentaires FFA1 comme représenté sur la figure 23. Le circuit FFA1 diffère du circuit FFA en ce qu'il comprend un circuit logique de commande CMLC et un circuit logique de comptage CPLC supplémentaires. Le circuit CMLC est configuré pour aiguiller les sorties complémentaires Cmd+ et Cmd- de l'oscillateur OSC sur des sorties complémentaires E1 et E1p ou E2 et E2p selon qu'une forme d'onde négative ou positive est à générer. La polarité de la forme d'onde à générer est définie par un signal de commande de polarité PB. Le circuit CMLC met en oeuvre la table de vérité suivante :

Tableau 4

| PB | E1 | E1p | E2 | E2p |
|----|------|------|------|------|
| 0 | Cmd+ | Cmd- | Cmd- | Cmd+ |
| 1 | Cmd- | Cmd+ | Cmd+ | Cmd- |

dans lequel le signal PB est à 0 pour générer une forme d'onde s(t) positive, et à 1 pour générer une forme d'onde négative.

Le circuit CMLC fournit par l'intermédiaire de tampons, par exemple deux tampons de type différentiel BFF6, BFF7, deux paires de signaux complémentaires E1, E1p et E2, E2p. Le circuit CPLC permet de sélectionner en fonction du signal PB parmi les signaux Cmd+ ou Cmd-, le signal dont les fronts descendants déclenchent un comptage du compteur CPT. Ainsi, le circuit CPLC fournit à l'entrée de comptage du compteur CPT le signal Cmd- si le signal PB est à 0 et le signal Cmd+ si le signal PB est à 1.

La figure 24 représente l'additionneur ADD5 et en particulier son mode de connexion au circuit FFA1. Le mode de connexion du circuit FFA1 à l'additionneur ADD5 diffère de celui représenté sur la figure 20 en ce que la grille du transistor M10 de chacune des portes TG12, TG13 reçoit le signal E1, la grille du transistor P10 de chacune des portes TG12, TG13 reçoit le signal E1 p, la grille du transistor M10 de chacune des portes TG22, TG23 reçoit le signal E2, et la grille du transistor P10 de chacune des portes TG22, TG23 reçoit le signal E2p.

Le mode de connexion de l'additionneur ADD5 au circuit AGN demeure inchangé (comme sur la figure 20), mais le circuit AGN est modifié pour comprendre un circuit du type CMLC permettant d'échanger les signaux V1, V1p par les signaux V2, V2p et réciproquement, lors de la génération d'une forme d'onde négative. De cette manière, selon la polarité de la forme d'onde à générer, lors de la génération de la première impulsion élémentaire, les signaux E1, E1p correspondent soit aux signaux Cmd+, Cmd-, soit aux signaux Cmd-, Cmd+ et inversement pour les signaux E2, E2p. Il en résulte que la première impulsion élémentaire de la forme d'onde est générée soit par la première branche produisant une impulsion élémentaire positive, soit par la seconde branche de l'additionneur ADD5 produisant une impulsion élémentaire négative. Au lieu de prévoir un circuit du type CMLC qui risque d'introduire des différences entre les impulsions positives et négatives, il peut être prévu de doubler le nombre de registres à décalage en entrée des convertisseurs analogiques numériques, avec un ensemble de registres étant prévu pour les impulsions positives et un ensemble de registres pour les impulsions négatives. Il peut être également prévu des commutateurs pour sélectionner l'un des deux ensembles de registres en fonction de la polarité de la forme d'onde à générer.

Les générateurs PGN, PGN1 sont adaptés à la compensation des variations PVT. Deux techniques de compensation peuvent être mises en oeuvre, séparément ou en combinaison. Une première technique consiste à effectuer une calibration en sortie de fabrication. Cette calibration consiste à répertorier toutes les formes d'onde à générer pour une application donnée et à déterminer les mots de commande permettant d'obtenir chacune de ces formes d'onde.

Une seconde technique consiste à effectuer une calibration dynamique du générateur, pendant son fonctionnement, de manière à maintenir des performances suffisantes, par exemple un taux d'erreur sur les bits (TEB) maximum dans le cadre d'une transmission de données.

La figure 25 représente un système de calibration comprenant une mémoire externe EMEM, une mémoire interne IMEM, un ensemble CNAS de convertisseurs numériques analogiques CNA1, CNA2, ... CNAL, un générateur de forme d'onde PGN2, une ligne à retard DLG, un calculateur de test TSTC et une porte logique de type OU OG1. Le générateur PGN2 peut être le générateur PGN ou PGN1 selon l'un des modes de réalisation décrits précédemment. Dans le cas du générateur PGN1, les convertisseurs CNA1..CNAL sont ceux du générateur. La mémoire EMEM comprend une sortie de données lues connectée à une entrée de données à écrire dans la mémoire IMEM. La mémoire IMEM comprend une sortie de données lues connectée à des entrées respectives des convertisseurs CNA1..CNAL. Chaque convertisseur CNA1..CNAL fournit une tension de consigne d'amplitude au générateur PGN2. Le générateur PGN2 fournit un signal s(t) au calculateur TSTC. Le calculateur TSTC fournit le signal de déclenchement Vdec au générateur PGN2, et des signaux TNK, TK indiquant si un test est positif ou négatif. La sortie TNK est connectée à une entrée de la porte OG1 et à une entrée de signal d'effacement ER de la mémoire IMEM. La sortie TK est connectée à une entrée de la porte OG1 et à une entrée d'incrémentation d'adresse de lecture ou d'écriture de la mémoire IMEM. La sortie de la porte OG1 est connectée à une entrée de la ligne à retard DLG et à une entrée d'incrémentation d'adresse de lecture de la mémoire EMEM. La mémoire EMEM mémorise toutes les valeurs possibles d'ensembles de mots de commande tels que représentés sur la figure 5 ou 21, selon le mode de réalisation du générateur PGN2.

Selon une procédure de calibration, les valeurs d'un premier ensemble de ces mots de commande à une première adresse de lecture sont transférées dans la mémoire IMEM à une première adresse. Les différentes valeurs des mots de commande transférées dans la mémoire IMEM sont transmises aux convertisseurs CNA1..CNAL. Les valeurs analogiques produites par les convertisseurs sont transmises aux entrées correspondantes du générateur PGN2. Après déclenchement du générateur PGN2 par le calculateur TSTC grâce au signal Vdec, le signal s(t) issu du générateur PGN2 est transmis au calculateur TSTC qui analyse le signal s(t). Le calculateur TSTC compare les caractéristiques du signal s(t) à un signal idéal en appliquant des critères de conformité. Ces critères peuvent être d'ordre temporel ou spectral et correspondent aux besoins d'une application (par exemple conformité du spectre du signal s(t) par rapport à une norme). Si le signal s(t) n'est pas conforme aux critères, le signal TNK est actif, produisant l'effacement de l'ensemble de mots de commande à l'adresse de lecture de la mémoire IMEM. Si le signal s(t) est conforme aux critères, le calculateur TSTC active le signal TK, produisant l'incrémentation de l'adresse de lecture de la mémoire IMEM. Il en résulte que le dernier ensemble de mots de commande transféré dans la mémoire interne IMEM est conservé. L'activation du signal TK ou TNK déclenche l'incrémentation de l'adresse de lecture de la mémoire EMEM pour lire un ensemble de mots de commande suivant et le transférer dans la mémoire IMEM, soit à l'adresse de l'ensemble de mots de commande précédent, effacé si le signal s(t) correspondant n'était pas conforme, soit à une adresse suivante, et la mise de la mémoire IMEM en mode écriture au travers de la ligne à retard DLG. A la fin de la procédure de calibration, la mémoire IMEM mémorise tous les mots de commande permettant d'obtenir un signal s(t) satisfaisant aux critères de conformité. Les valeurs d'un seul ensemble de mots de commande peuvent être retenues à l'issue de la procédure de calibration, en sélectionnant l'ensemble de mots de commande donnant le meilleur résultat, par exemple celui qui permet d'obtenir le signal le plus puissant. La mémoire IMEM peut alors être réduite à un seul registre capable de mémoriser un ou deux ensembles de mots de commande.

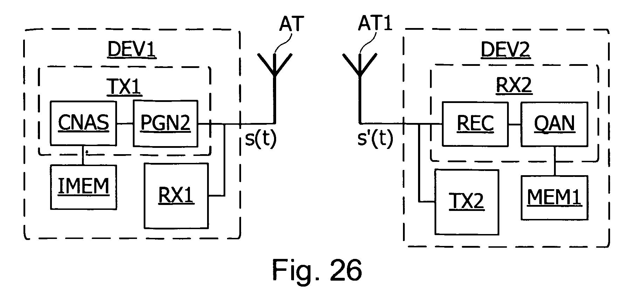

Une calibration dynamique peut également être effectuée par exemple dans le cadre d'une transmission de données entre un émetteur et un récepteur, pour garantir une qualité de service QoS maximale. Ainsi, la figure 26 représente un système de transmission de données mettant en oeuvre le générateur PGN2. Le système de transmission comprend deux dispositifs DEV1, DEV2 comprenant chacun un émetteur de données TX1, TX2 et un récepteur de données RX1, RX2 configuré pour recevoir les données émises par l'émetteur TX1, TX2 de l'autre dispositif. L'émetteur TX1 et le récepteur RX1 sont connectés à une antenne AT. De même, l'émetteur TX2 et le récepteur RX2 sont connectés à une antenne AT1. Au moins l'émetteur TX1 comprend le générateur PGN2 selon l'un des modes de réalisation précédemment décrits, connecté à l'antenne AT, et dans le cas du générateur PGN, l'ensemble de convertisseurs numériques analogiques CNAS connecté entre la mémoire IMEM et le générateur PGN2. Les convertisseurs CNAS reçoivent des ensembles de mots de commande mémorisés dans la mémoire IMEM, et fournissent des signaux analogiques de commande au générateur PGN2. Au moins le récepteur RX2 comprend des circuits de réception REC connectés à un circuit d'analyse QAN de qualité de service QoS des signaux reçus, le circuit QAN étant connecté à une mémoire MEM1.

Durant une phase de calibration, le générateur PGN2 et la mémoire IMEM sont commandés pour générer et émettre un premier signal s(t) à partir d'un premier ensemble de mots de commande lu dans la mémoire IMEM, le signal s(t) émis étant modulé par une trame de test contenant par exemple l'adresse de l'ensemble de mots de commande lu dans la mémoire IMEM. Le récepteur RX2 reçoit un signal s'(t) correspondant au signal s(t) émis. Le récepteur RX2 mesure la qualité du signal s'(t) et mémorise dans la mémoire MEM1 l'adresse de l'ensemble de mots de commande transmis dans le signal s'(t) en association avec la qualité de signal mesurée. L'émetteur TX2 du dispositif DEV2 envoie au dispositif DEV1 un message d'acquittement ou bien attend une trame suivante. Suite à la réception du message d'acquittement par le récepteur RX1 du dispositif DEV1, ou suite à l'échéance d'une temporisation d'une certaine durée correspondant à un temps de traitement et de réponse par le dispositif DEV2, l'émetteur TX1 accède à un ensemble de mots de commande suivant dans la mémoire IMEM et le générateur PGN2 commandé par l'intermédiaire du nouvel ensemble de mots de commande sélectionné, génère un nouveau signal s(t) qui est modulé par la trame de test incluant la nouvelle adresse de lecture de la mémoire IMEM. Le récepteur RX2 du dispositif DEV2 reçoit ce signal, effectue une nouvelle mesure de qualité du signal reçu et mémorise dans la mémoire MEM1 l'adresse transmise et la mesure de qualité obtenue. Une fois que tous les ensembles de mots de commande ont été lus dans la mémoire IMEM et utilisés pour générer un signal de trame de test, le dispositif DEV1 envoie au dispositif DEV2 un signal de fin de calibration. A la réception de ce signal de fin de calibration, le dispositif DEV2 recherche dans la mémoire MEM1, l'adresse correspondant à la meilleure mesure de qualité et envoie cette adresse au dispositif DEV1 en réponse au signal de fin de calibration. Le dispositif DEV1 peut alors configurer l'émetteur TX1 pour qu'il utilise l'ensemble de mots de commande se trouvant dans la mémoire IMEM à l'adresse transmise par le dispositif DEV2. Si la qualité de la transmission mesurée par le dispositif DEV2 devient insuffisante, le dispositif DEV2 peut envoyer au dispositif DEV1 un signal de déclenchement d'une nouvelle calibration.

Bien entendu, la procédure de calibration qui vient d'être décrite entre l'émetteur TX1 et le récepteur RX2 peut être également effectuée entre l'émetteur TX2 et le récepteur RX1.

Il apparaîtra clairement à l'homme de l'art que la présente invention est susceptible de diverses variantes de réalisation et diverses applications. En particulier, l'invention n'est pas limitée à l'usage d'un oscillateur commandé. D'autres moyens connus peuvent être employés pour générer des trains d'impulsions.

L'invention n'est pas non plus limitée à l'utilisation d'un pont en H pour combiner les signaux d'impulsion et les signaux de consigne d'amplitude des impulsions.

Documents de l'art antérieur cités:

[1] S. Bourdel, Y. Bachelet, J. Gaubert, R. Vauché, O. Fourquin, N. Dehaese, and H. Barthelemy; "A 9pJ/Pulse 1.42Vpp OOK CMOS UWB Pulse Generator for the 3.1-10.6 GHz FCC Band"; Microwave Theory and Techniques, IEEE Transaction on; January 2010

[2] Wentzloff, D.D.; Chandrakasan, A.P.; "A 47pJ/pulse 3.1-to-5GHz AllDigital UWB Transmitter in 90nm CMOS"; Solid-State Circuits Conference, 2007. ISSCC 2007. Digest of Technical Papers. IEEE International; 11-15 Feb. 2007, Page(s) 118 - 591.

[3] Sanghoon Sim; Dong-Wook Kim; Songcheol Hong; "A CMOS UWB Pulse Generator for 6-10 GHz Applications"; Microwave and Wireless Components Letters, IEEE; Volume 19, Issue 2, Feb. 2009, Page(s) 83 - 85.

[4] Bachelet, Y.; Bourdel, S.; Gaubert, J.; Bas, G.; Chalopin, H.; "Fully integrated CMOS UWB pulse generator", Electronics Letters, Volume 42 Issue 22, Oct. 26 2006, Page(s) 1277 - 1278.

[5] Jeongwoo Han; Cam Nguyen; "Ultra-wideband electronically tunable pulse generators"; Microwave and Wireless Components Letters, IEEE; Volume 14, Issue 3, March 2004, Page(s) 112 - 114.

[6] Tuan-Anh Phan; Jeongseon Lee; Krizhanovskii, V.; Seok-Kyun Han; Sang-Gug Lee; "A 18-pJ/Pulse OOK CMOS Transmitter for Multiband UWB Impulse Radio"; Microwave and Wireless Components Letters, IEEE; Volume 17, Issue 9, Sept. 2007, Page(s) 688 - 690.

[7] Phan, A. T.; Lee, J.; Krizhanovskii, V.; Le, Q.; Han, S.-K.; Lee, S.-G.; "Energy-Efficient Low-Complexity CMOS Pulse Generator for Multiband UWB Impulse Radio"; Circuits and Systems I: Regular Papers, IEEE Transactions on; Volume 55, Issue 11, Dec. 2008, Page(s) 3552 - 3563

[8] H. Kim, D. Park, and Y. Joo, "All-Digital Low-Power CMOS Pulse Generator for UWB system", Electronic Letters, vol. 40, no.24, 25 November 2004.

[9] Wentzloff, D.D.; Chandrakasan, A.P.; "A 47pJ/pulse 3.1-to-5GHz AllDigital UWB Transmitter in 90nm CMOS"; Solid-State Circuits Conference, 2007. ISSCC 2007. Digest of Technical Papers. IEEE International; 11-15 Feb. 2007 Page(s) 118 - 591.

[10]S. Bourdel, Y. Bachelet, J. Gaubert, M. Battista, M. Egels, N. Dehaese, "Low-Cost CMOS Pulse Generator for UWB Systems", Electronic Letters, vol. 43, issue 25, 6 December 2007, pp. 1425-1427.

## Revendications

1. Procédé de génération de formes d'onde UWB comprenant chacune une séquence d'impulsions élémentaires, le procédé comprenant des étapes consistant à :

   générer au moins deux signaux d'impulsion (E1, E2) comportant chacun un train d'impulsions élémentaires (e1, e2, ...) sensiblement de même amplitude et de durée correspondant à une durée de consigne, les impulsions élémentaires apparaissant alternativement dans l'un et l'autre des deux trains d'impulsions,

   pour chaque signal d'impulsion, générer un signal d'amplitude (V1, V2) fournissant pour chaque impulsion élémentaire et lors de son apparition dans le signal d'impulsion, une consigne d'amplitude (Va1, Va2, ...) de l'impulsion élémentaire,

   combiner les signaux d'impulsion et les signaux d'amplitude pour obtenir une forme d'onde (s) comprenant successivement chacune des impulsions élémentaires amplifiées, et alternativement positives et négatives, les impulsions élémentaires étant amplifiées conformément à la consigne d'amplitude de l'impulsion élémentaire, fournie par l'un des signaux d'amplitude.

2. Procédé de génération selon la revendication 1, dans lequel les trains d'impulsions élémentaires sont générés par un oscillateur (OSC) fournissant un signal (Cmd+, Cmd-) dont la période peut être ajustée à une valeur correspondant à la durée de consigne (VN).

3. Procédé de génération selon la revendication 1 ou 2, dans lequel les impulsions élémentaires sont amplifiées et combinées dans un circuit à pont en H (ADD5) comprenant au moins une première branche (B1) recevant un premier des signaux d'impulsion (E1) et le signal d'amplitude correspondant (V1), et au moins une seconde branche (B2) recevant un second des signaux d'impulsion (E2) et le signal d'amplitude correspondant (V2).

4. Procédé de génération selon la revendication 3, dans lequel le signal d'impulsion (E1, E2) est introduit dans une branche (B1, B2) du circuit à pont en H (ADD5) par la grille d'au moins deux transistors (M10, TG12, TG13, TG22, TG23) montés en série dans la branche.

5. Procédé de génération selon la revendication 3 ou 4, dans lequel l'un des signaux d'amplitude (V1, V2) est introduit dans une branche (B1, B2) du circuit à pont en H (ADD5) par la grille d'au moins deux transistors (M10, TG11, TG14, TG21, TG24) montés en série dans la branche.

6. Procédé de génération selon l'une des revendications 1 à 5, comprenant des étapes de génération d'une forme d'onde de polarité positive et de génération d'une forme d'onde de polarité négative, la forme d'onde de polarité négative comprenant un même nombre d'impulsions élémentaires que la forme d'onde de polarité positive, chaque impulsion élémentaire dans l'une des formes d'onde ayant la même amplitude et une polarité opposée à une impulsion élémentaire de même rang dans l'autre forme d'onde.

7. Procédé de génération selon la revendication 6, dans lequel les impulsions élémentaires sont amplifiées et combinées dans un circuit à pont en H (ADD5), une forme d'onde de polarité positive étant générée en introduisant un premier des deux signaux d'impulsion (E1, E2) dans une branche impaire du circuit à pont en H, et un second des signaux d'impulsion dans une branche paire du circuit à pont en H, une forme d'onde de polarité négative étant générée en introduisant le premier signal d'impulsion (E1) dans la branche paire du circuit à pont en H, et le second signal d'impulsion (E2) dans la branche impaire du circuit à pont en H.

8.  Procédé de transmission de données binaires, comprenant des étapes de génération d'une forme d'onde de polarité positive ou négative, selon qu'une donnée binaire à 0 ou à 1 est transmise, et d'émission des formes d'onde générées, la forme d'onde de polarité négative comprenant un même nombre d'impulsions élémentaires que la forme d'onde de polarité positive, chaque impulsion élémentaire dans l'une des formes d'onde ayant la même amplitude et une polarité opposée à une impulsion élémentaire de même rang dans l'autre forme d'onde, la génération des formes d'onde étant réalisée conformément au procédé selon l'une des revendications 1 à 7.

9.  Procédé de transmission selon la revendication 8, comprenant une phase de calibration comportant plusieurs étapes de transmission d'un message de calibration, chaque étape de transmission consistant à :

    générer une forme d'onde distincte en ce qui concerne les amplitudes et/ou les durées de ses impulsions élémentaires, identifiée par un identifiant de forme d'onde,
    émettre un message de calibration contenant l'identifiant de forme d'onde, à l'aide de la forme d'onde, et
    recevoir le message de calibration et déterminer une mesure de qualité de transmission à partir du message de calibration reçu,
    le procédé comprenant une étape finale de sélection d'une forme d'onde parmi les formes d'ondes utilisées pour transmettre un message de calibration, en fonction des mesures de qualité de transmission obtenues.

10. Générateur de forme d'onde UWB comprenant un générateur d'impulsions (PGN1) configuré pour mettre en oeuvre le procédé selon l'une des revendications 1 à 7.

11. Générateur selon la revendication 10, comprenant un oscillateur (OSC) produisant un signal de sortie (Cmd+, Cmd-) ayant une fréquence commandée en fonction d'une durée de consigne, et définissant la durée des impulsions élémentaires.

12. Générateur selon l'une des revendications 10 et 11, dans lequel l'additionneur (ADD5) comprend un pont en H comportant au moins une première branche (B1) recevant un premier des signaux d'impulsions (E1) et le signal d'amplitude (V1) du premier signal impulsion, et au moins une seconde branche (B2) recevant un second des signaux d'impulsions (E2) et le signal d'amplitude (V2) du second signal d'impulsion.

13. Générateur selon revendication 12, dans lequel chaque branche (B1, B2) de l'additionneur (ADD5) comprend au moins deux transistors (M10, TG12, TG13, TG22, TG23) montés en série dans la branche et recevant sur leur grille l'un des signaux d'impulsion élémentaire (E1, E2) à amplifier et combiner.

14. Générateur selon la revendication 13, dans lequel chaque branche (B1, B2) de l'additionneur (ADD5) comprend au moins deux transistors (M10, TG11, TG14, TG21, TG24) montés en série dans la branche et recevant sur leur grille l'un des signaux d'amplitude (V1, V2).

15. Emetteur comprenant un générateur de forme d'onde selon l'une des revendications 10 à 14.

**Patentansprüche**

1.  Verfahren zur Erzeugung von UWB-Wellenformen, jeweils umfassend eine Sequenz von Elementarimpulsen, das Verfahren umfassend die folgenden Schritte, die darin bestehen:

    wenigstens zwei Impulssignale (E1, E2) zu erzeugen, die jeweils eine Folge von Elementarimpulsen (e1, e2, ...) aufweisen, die von wesentlich gleicher Amplitude sind und deren Dauer einer Solldauer entspricht, wobei die Elementarimpulse abwechselnd in der einen und anderen Impulsfolge auftreten,
    für jedes Impulssignal ein Amplitudensignal (V1, V2) zu erzeugen, das für jeden Elementarimpuls und bei dessen Auftreten in dem Impulssignal, einen Amplitudensollwert (Va1, Va2, ...) des Elementarimpulses liefert,
    die Impulssignale und die Amplitudensignale zu kombinieren, um eine Wellenform (s) zu erhalten, die jeden der verstärkten abwechselnd positiv und negativ Elementarimpulse nacheinander umfasst, wobei die Elementarimpulse gemäß dem von einem der Amplitudensignale gelieferten Amplitudensollwert des Elementarimpulses verstärkt sind.

2.  Erzeugungsverfahren nach Anspruch 1, bei dem die Elementarimpulsfolgen von einem Oszillator (OSC) erzeugt sind, der ein Signal (Cmd+, Cmd-) liefert, dessen Periode auf einen der Solldauer (VN) entsprechenden Wert eingestellt werden kann.

3.  Erzeugungsverfahren nach Anspruch 1 oder 2, bei dem die Elementarimpulse verstärkt und in einer H-Brückenschaltung (ADD5) kombiniert sind, wobei die H-Brückenschaltung (ADD5) wenigstens einen ersten Zweig (B1) umfasst, der ein erstes der Impulssignale (E1) und das entsprechende Amplitudensignal (V1) empfängt, sowie wenigstens einen zweiten Zweig (B2), der ein zweites der Impulssignale (E2) und das entsprechende Amplitudensignal (V2) empfängt.

4.  Erzeugungsverfahren nach Anspruch 3, bei dem das Impulssignal (E1, E2) in einen Zweig (B1, B2) der H-Brückenschaltung (ADD5) über das Gitter von wenigstens zwei im Zweig in Reihe geschalteten Transistoren (M10, TG12, TG13, TG22, TG23) eingeführt ist.

5.  Erzeugungsverfahren nach Anspruch 3 oder 4, bei dem eines der Amplitudensignale (V1, V2) in einen Zweig (B1, B2) der H-Brückenschaltung (ADD5) über das Gitter von wenigstens zwei im Zweig in Reihe geschalteten Transistoren (M10, TG11, TG14, TG21, TG24) eingeführt ist.

6.  Erzeugungsverfahren nach einem der Ansprüche 1 bis 5, umfassend Schritte der Erzeugung einer Wellenform mit positiver Polarität und der Erzeugung einer Wellenform mit negativer Polarität, wobei die Wellenform mit negativer Polarität ebenso viele Elementarimpulse umfasst, wie die Wellenform mit positiver Polarität, wobei jeder Elementarimpuls in einer der Wellenformen dieselbe Amplitude hat, wie ein Elementarimpuls derselben Reihe in der anderen Wellenform und eine Polarität, die diesem entgegengesetzt ist.

7.  Erzeugungsverfahren nach Anspruch 6, bei dem die Elementarimpulse verstärkt und in einer H-Brückenschaltung (ADD5) kombiniert sind, wobei eine Wellenform mit positiver Polarität erzeugt wird, indem ein erstes der zwei Impulssignale (E1, E2) in einen ungeraden Zweig der H-Brückenschaltung, und ein zweites der Impulssignale in einen geraden Zweig der H-Brückenschaltung eingeführt wird, wobei eine Wellenform mit negativer Polarität erzeugt wird, indem das erste Impulssignal (E1) in den geraden Zweig der H-Brückenschaltung, und das zweite Impulssignal (E2) in den ungeraden Zweig der H-Brückenschaltung eingeführt wird.

8.  Verfahren zur Übertragung von Binärdaten, umfassend Schritte der Erzeugung einer Wellenform mit positiver oder negativer Polarität, je nachdem, ob ein Binärdatum zu 0 oder zu 1 übertragen wird, und des Sendens der erzeugten Wellenformen, wobei die Wellenform mit negativer Polarität ebenso viele Elementarimpulse umfasst, wie die Wellenform mit positiver Polarität, wobei jeder Elementarimpuls in einer der Wellenformen dieselbe Amplitude hat, wie ein Elementarimpuls derselben Reihe in der anderen Wellenform und eine Polarität, die diesem entgegengesetzt ist, wobei die Erzeugung der Wellenformen gemäß dem Verfahren nach einem der Ansprüche 1 bis 7 ausgeführt wird.

9.  Übertragungsverfahren nach Anspruch 8, umfassend eine aus mehreren Schritten der Übertragung einer Eichnachricht bestehende Eichphase, wobei jeder Übertragungsschritt darin besteht:

    eine in Hinsicht auf die Amplituden und/oder die Dauer ihrer Elementarimpulse unterschiedliche Wellenform zu erzeugen, die durch einen Wellenformidentifizierer identifiziert ist,
    anhand der Wellenform eine den Wellenformidentifizierer enthaltende Eichnachricht zu senden, und
    die Eichnachricht zu empfangen und aus der empfangenen Eichnachricht eine Übertragungsqualitätsmessung festzustellen,
    wobei das Verfahren einen Endschritt umfasst, der darin besteht, eine Wellenform unter den zur Übertragung einer Eichnachricht genutzten Wellenformen abhängig von den erhaltenen Übertragungsqualitätsmessungen auszuwählen.

10. UWB-Wellenformgenerator, umfassend einen Impulsgenerator (PGN1), der konfiguriert ist, um das Verfahren nach einem der Ansprüche 1 bis 7 durchzuführen.

11. Generator nach Anspruch 10, umfassend einen Oszillator (OSC), der ein Ausgangssignal (Cmd+, Cmd-) erzeugt, das eine je nach einer Solldauer gesteuerte Frequenz hat, und das die Dauer der Elementarimpulse bestimmt.

12. Generator nach einem der Ansprüche 10 und 11, bei dem der Addierer (ADD5) eine H-Brücke umfasst, mit wenigstens einem ersten Zweig (B1), der ein erstes der Impulssignale (E1) und das Amplitudensignal (V1) des ersten Impulssignals empfängt, und wenigstens einem zweiten Zweig (B2), der ein zweites der Impulssignale (E2) und das Amplitudensignal (V2) des zweiten Impulssignals empfängt.

13. Generator nach Anspruch 12, bei dem jeder Zweig (B1, B2) des Addierers (ADD5) wenigstens zwei im Zweig in Reihe geschaltete Transistoren (M10, TG12, TG13, TG22, TG23) umfasst, die auf ihrem Gitter eines der zu verstärkenden und zu kombinierenden Elementarimpulssignale (E1, E2) empfangen.

14. Generator nach Anspruch 13, bei dem jeder Zweig (B1, B2) des Addierers (ADD5) wenigstens zwei im Zweig in Reihe geschaltete Transistoren (M10, TG11, TG14, TG21, TG24) umfasst, die auf ihrem Gitter eines der Amplitudensignale (V1, V2) empfangen.

15. Sendegerät umfassend einen Wellenformgenerator nach einem der Ansprüche 10 bis 14.

**Claims**

1. Method of generating UWB waveforms, each comprising a sequence of elementary pulses, the method comprising steps of:

   generating at least two pulse signals (E1, E2), each comprising a stream of elementary pulses (e1, e2, ...) of substantially the same amplitude and of duration corresponding to a setpoint duration, the elementary pulses alternately appearing in one and the other of the two pulse streams,
   generating, for each pulse signal, an amplitude signal (V1, V2) supplying, for each elementary pulse and during the apparition thereof in the pulse signal, an amplitude setpoint (Va1, Va2, ...) of the elementary pulse,
   combining the pulse signals and the amplitude signals to obtain a waveform (s) successively comprising each of the amplified elementary pulses, alternately positive and negative, the elementary pulses being amplified in accordance with the amplitude setpoint of the elementary pulse, supplied by one of the amplitude signals.

2. Generation method according to claim 1, wherein the elementary pulses are generated by an oscillator (OSC) supplying a signal (Cmd+, Cmd-), the period of which may be adjusted to a value corresponding to the setpoint duration (VN).

3. Generation method according to one of claims 1 or 2, wherein the elementary pulses are amplified and combined in an H-bridge circuit (ADD5) comprising at least a first branch (B1) receiving a first of the pulse signals (E1) and the corresponding amplitude signal (V1), and at least a second branch (B2) receiving a second of the pulse signals (E2) and the corresponding amplitude signal (V2).

4. Generation method according to claim 3, wherein the pulse signal (E1, E2) is introduced into a branch (B1, B2) of the H-bridge circuit (ADD5) through the gates of at least two transistors (M10, TG12, TG13, TG22, TG23) mounted in series in the branch.

5. Generation method according to one of claims 3 or 4, wherein one of the amplitude signals (V1, V2) is introduced into a branch (B1, B2) of the H-bridge circuit (ADD5) through the gates of at least two transistors (M10, TG11, TG14, TG21, TG24) mounted in series in the branch.

6. Generation method according to one of claims 1 to 5, comprising the steps of generating a waveform of positive polarity and generating a waveform of negative polarity, the waveform of negative polarity comprising a same number of elementary pulses as the waveform of positive polarity, each elementary pulse in one of the waveforms having the same amplitude and an opposite polarity of an elementary pulse of the same rank in the other waveform.

7. Generation method according to claim 6, wherein the elementary pulses are amplified and combined in an H-bridge circuit (ADD5), a waveform of positive polarity being generated by introducing a first of the two pulse signals (E1, E2) into an odd branch of the H-bridge circuit, and a second of the pulse signals into an even branch of the H-bridge circuit, a waveform of negative polarity being generated by introducing the first pulse signal (E1) into the even branch of the H-bridge circuit, and the second pulse signal (E2) into the odd branch of the H-bridge circuit.

8. Method of transmitting binary data, comprising the steps of generating a waveform of positive or negative polarity, depending on whether a binary data of 0 or 1 is transmitted, and emitting generated waveforms, the waveform of negative polarity comprising a same number of elementary pulses as the waveform of positive polarity, each elementary pulse in one of the waveforms having the same amplitude and an opposite polarity of an elementary pulse of the same rank in the other waveform, the generation of the waverforms being performed in accordance with the method according to one of claims 1 to 7.

9. Transmission method according to claim 8, comprising a calibration phase comprising several transmission steps of a calibration message, each transmission step comprising:

generating a waveform identified by a waveform identifier and distinct as to the amplitudes and/or durations of the elementary pulses thereof;

emitting a calibration message comprising the waveform identifier, using the waveform; and

receiving the calibration message and determining a transmission quality measure from the calibration message received;

the method comprising a final step of selecting a waveform among the waveforms used to transmit a calibration message, as a function of the received transmission quality measures.

10. A UWB waveform generator comprising a pulse generator (PGN1) configured to implement the method according to one of claims 1 to 7.

11. Generator according to claim 10, comprising an oscillator (OSC) producing an output signal (Cmd+, Cmd-), the frequency of which is controlled as a function of a setpoint duration, and defining the duration of the elementary pulses.

12. Generator according to one of claims 10 and 11, wherein the adder (ADD5) comprises an H-bridge comprising at least a first branch (B1) receiving a first of the pulse signals (E1) and the amplitude signal (V1) of the first pulse signal, and at least a second branch (B2) receiving a second of the pulse signals (E2) and the amplitude signal (V2) of the second pulse signal.

13. Generator according to claim 12, wherein each branch (B1, B2) of the adder (ADD5) comprises at least two transistors (M10, TG12, TG13, TG22, TG23) mounted in series in the branch and receiving on their gates one of the elementary pulse signals (E1, E2) to be amplified and combined.

14. Generator according to claim 13, wherein each branch (B1, B2) of the adder (ADD5) comprises at least two transistors (M10, TG11, TG14, TG21, TG24) mounted in series in the branch and receiving on their gates one of the amplitude signals (V1, V2).

15. Transmitter comprising a waveform generator according to one of claims 10 to 14.

Fig. 1a  Fig. 1b

Fig. 2

Fig. 2a

Fig. 3

Fig. 4

| MA1 | ··· | MAi | ··· | MA2n | VN1 | ··· | VNi | ·· | VN2n | D1 | ··· | Di | ··· | D2n |

Fig. 5

Fig. 6

Fig. 7

Fig. 8

Fig. 9a

Fig. 9b

Fig. 9c

Fig. 9d

Fig. 10a

Fig. 10b

Fig. 11a

Fig. 11b

Fig. 12

Fig. 13

Fig. 14

Fig. 15a

Fig. 15b

Fig. 15c

Fig. 15d

Fig. 16

Fig. 17

Fig. 17a

Fig. 18

Fig. 19

Fig. 20

| MA11 | ··· | MA1N | MA21 | ··· | MA2N | VN |

Fig. 21

Fig. 22a

Fig. 22b

Fig. 22c

Fig. 22d

Fig. 22e

Fig. 23

FFA1

Fig. 24

Fig. 25

Fig. 26

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. BOURDEL ; Y. BACHELET ; J. GAUBERT ; R. VAUCHÉ ; O. FOURQUIN ; N. DEHAESE ; H. BAR-THELEMY.** A 9pJ/Pulse 1.42Vpp OOK CMOS UWB Pulse Generator for the 3.1-10.6 GHz FCC Band. *Microwave Theory and Techniques, IEEE Transaction,* Janvier 2010

- **WENTZLOFF, D.D. ; CHANDRAKASAN, A.P.** A 47pJ/pulse 3.1-to-5GHz AllDigital UWB Transmitter in 90nm CMOS. *Solid-State Circuits Conference, 2007. ISSCC 2007. Digest of Technical Papers,* 11 Février 2007, 118-591

- **SANGHOON SIM ; DONG-WOOK KIM ; SONGCHEOL HONG.** A CMOS UWB Pulse Generator for 6-10 GHz Applications. *Microwave and Wireless Components Letters,* Février 2009, vol. 19 (2), 83-85

- **BACHELET, Y. ; BOURDEL, S. ; GAUBERT, J. ; BAS, G. ; CHALOPIN, H.** Fully integrated CMOS UWB pulse generator. *Electronics Letters,* 26 Octobre 2006, vol. 42 (22), 1277-1278

- **JEONGWOO HAN ; CAM NGUYEN.** Ultra-wideband electronically tunable pulse generators. *Microwave and Wireless Components Letters,* Mars 2004, vol. 14 (3), 112-114

- **TUAN-ANH PHAN ; JEONGSEON LEE ; KRIZH-ANOVSKII, V. ; SEOK-KYUN HAN ; SANG-GUG LEE.** A 18-pJ/Pulse OOK CMOS Transmitter for Multiband UWB Impulse Radio. *Microwave and Wireless Components Letters,* Septembre 2007, vol. 17 (9), 688-690

- **PHAN, A. T. ; LEE, J ; KRIZHANOVSKII, V. ; LE, Q. ; HAN, S.-K. ; LEE, S.-G.** Energy-Efficient Low-Complexity CMOS Pulse Generator for Multiband UWB Impulse Radio. *Circuits and Systems I: Regular Papers, IEEE Transactions,* Décembre 2008, vol. 55 (11), 3552-3563

- **H. KIM ; D. PARK ; Y. JOO.** All-Digital Low-Power CMOS Pulse Generator for UWB system. *Electronic Letters,* 25 Novembre 2004, vol. 40 (24

- **WENTZLOFF, D.D. ; CHANDRAKASAN, A.P.** A 47pJ/pulse 3.1-to-5GHz AllDigital UWB Transmitter in 90nm CMOS. *Solid-State Circuits Conference, 2007. ISSCC 2007. Digest of Technical Papers. IEEE International,* 11 Février 2007, 118-591

- **S. BOURDEL ; Y. BACHELET ; J. GAUBERT ; M. BATTISTA ; M. EGELS ; N. DEHAESE.** Low-Cost CMOS Pulse Generator for UWB Systems. *Electronic Letters,* 06 Décembre 2007, vol. 43 (25), 1425-1427